# EUROPEAN PATENT APPLICATION

(11) **EP 4 841 631 A1**
(43) Date of publication of application: **18.11.2026**
(21) Application number: 26176696.8
(22) Date of filing: 05.05.2026
(51) Int. Cl.: G11C 5/02

(54) **NON-VOLATILE MEMORY DEVICE**

(30) Priority: 14.05.2025 KR 20250062857; 21.10.2025 KR 20250152265
(71) Applicant: Samsung Electronics Co., Ltd., Suwon-si, Gyeonggi-do 16677 (KR)
(72) Inventor: SONG, Seunghwan, 16677 Suwon-si (KR); KIM, Wandong, 16677 Suwon-si (KR); JEONG, Youngseok, 16677 Suwon-si (KR); SONG, Kiwhan, 16677 Suwon-si (KR); KIM, Yoonjung, 16677 Suwon-si (KR); KIM, Suhyun, 16677 Suwon-si (KR)
(74) Representative: Marks & Clerk LLP

(57) **Abstract**

A non-volatile memory device includes a first memory chip, a second memory chip, and an input/output circuit. The input/output circuit communicates with each of first planes of the first memory chip through a first data input/output line that is provided as a through via in a through silicon via (TSV) area of the first memory chip and the second memory chip along the first direction and connected for each of the first planes, and communicate with each of second planes of the second memory chip through a second data input/output line that is provided as a through via in the TSV area and connected for each of the second planes.

## Description

### BACKGROUND

Embodiments of the present disclosure described herein relate to a non-volatile memory device.

A semiconductor memory device may be classified as a volatile memory device or a non-volatile memory device. The volatile memory device is fast in read and write speeds but loses data stored therein when a power is turned off. In contrast, even though a power is turned off, the non-volatile memory device retains information stored therein. Therefore, the non-volatile memory device is used to store information which has to be retained regardless of whether a power is supplied.

A flash memory device may be a representative example of the non-volatile memory device. The flash memory device is used as a medium for storing audio and image data of information devices such as a computer, a mobile phone, a smartphone, a personal digital assistant (PDA), a digital camera, a voice recorder, an MP3 player, a handheld PC, a game console, a facsimile, a scanner, and/or a printer. As information devices using the non-volatile memory device as a storage device increase, nowadays, there is a need to improve data input/output performance of the non-volatile memory device.

### SUMMARY

It is an aspect to provide a non-volatile memory device having a stacked structure through a through silicon via (TSV) area and having improved core and input/output (I/O) performance.

According to an aspect of one or more embodiments, a non-volatile memory device may include a first memory chip including a plurality of first planes, each including a first memory cell array and a first page buffer circuit, the first page buffer circuit including a first cache latch that caches data sensed from the first memory cell array; a second memory chip stacked on the first memory chip along a first direction and including a plurality of second planes, each including a second memory cell array and a second page buffer circuit, the second page buffer circuit including a second cache latch that caches data sensed from the second memory cell array; and an input/output circuit. The input/output circuit may be configured to communicate with each of the plurality of first planes of the first memory chip through a first data input/output line that is provided as a through via in a through silicon via (TSV) area of the first memory chip and the second memory chip along the first direction and connected for each of the plurality of first planes, and communicate with each of the plurality of second planes of the second memory chip through a second data input/output line that is provided as a through via in the TSV area and connected for each of the plurality of second planes.

According to another aspect of one or more embodiments, a non-volatile memory device may comprise a base die; and a plurality of memory chips sequentially stacked on the base die along a first direction. Each of the plurality of memory chips may include a plurality of planes, each including a memory cell array and a page buffer circuit, the page buffer circuit including a cache latch that caches data sensed from the memory cell array. The base die may include an input/output circuit configured to communicate with each of the plurality of planes of the plurality of memory chips through a data input/output line that is provided as a through via in a through silicon via (TSV) area of the plurality of memory chips along the first direction and connected for each of the plurality of planes.

According to yet another aspect of one or more embodiments, a non-volatile memory device may include a plurality of memory chips sequentially stacked along a first direction; and an input/output circuit connected to the plurality of memory chips. Each of the plurality of memory chips may include a plurality of planes, each including a memory cell array and a page buffer circuit, the page buffer circuit including a cache latch that caches data sensed from the memory cell array. The input/output circuit may be configured to receive, for each of the plurality of planes, data output from the cache latch after a given caching time through a data input/output line that is provided as a through via in a through silicon via (TSV) area of the plurality of memory chips along the first direction and connected for each of the plurality of planes.

At least some of the above and other features of the invention are set out in the claims.

### BRIEF DESCRIPTION OF THE FIGURES

The above and other aspects will become apparent by describing in detail embodiments thereof with reference to the accompanying drawings, in which:
FIG. 1 is a block diagram of a memory system according to an embodiment;
FIG. 2 is a block diagram of a memory controller of the memory system of FIG. 1, according to some example embodiments;
FIG. 3 is a block diagram of a non-volatile memory device corresponding to a plane, according to an embodiment;
FIG. 4 is a block diagram of a page buffer according to an embodiment;
FIG. 5 is a block diagram of a plurality of memory chips and planes of each memory chip, according to an embodiment;
FIG. 6 is a block diagram of a plane included in one memory chip of the plurality of memory chips of FIG. 5, according to an embodiment;
FIG. 7 illustrates a plurality of memory chips included in a non-volatile memory device according to an embodiment;
FIG. 8 illustrates a non-volatile memory device according to an embodiment;
FIG. 9 illustrates a non-volatile memory device according to an embodiment;
FIG. 10 illustrates a read operation of a non-volatile memory device, according to an embodiment;
FIG. 11 illustrates how to apply a read command to a non-volatile memory device and how to perform a core operation, according to an embodiment;
FIG. 12 illustrates how to interleave read commands to a non-volatile memory device and how to perform core operations based on the read commands, according to an embodiment;
FIG. 13 illustrates a read operation and a program operation of a non-volatile memory device, according to an embodiment;
FIG. 14 illustrates how to apply a read command and a program command to a non-volatile memory device and how to perform a core operation, according to an embodiment;
FIG. 15 is a block diagram of an input/output circuit according to an embodiment;
FIG. 16 is a block diagram including a plurality of data input/output circuits according to an embodiment;
FIG. 17 is a block diagram including a plurality of data input/output circuits according to an embodiment;
FIG. 18 illustrates a page read operation and a data output operation for each plane, according to an embodiment;
FIG. 19 illustrates a data read operation and a data output operation for each plane, according to an embodiment; and
FIG. 20 is a flowchart of an operating method of a non-volatile memory device, according to an embodiment.

### DETAILED DESCRIPTION

Below, various embodiments of the present disclosure will be described in detail and clearly to such an extent that one skilled in the art easily carries out the present disclosure.

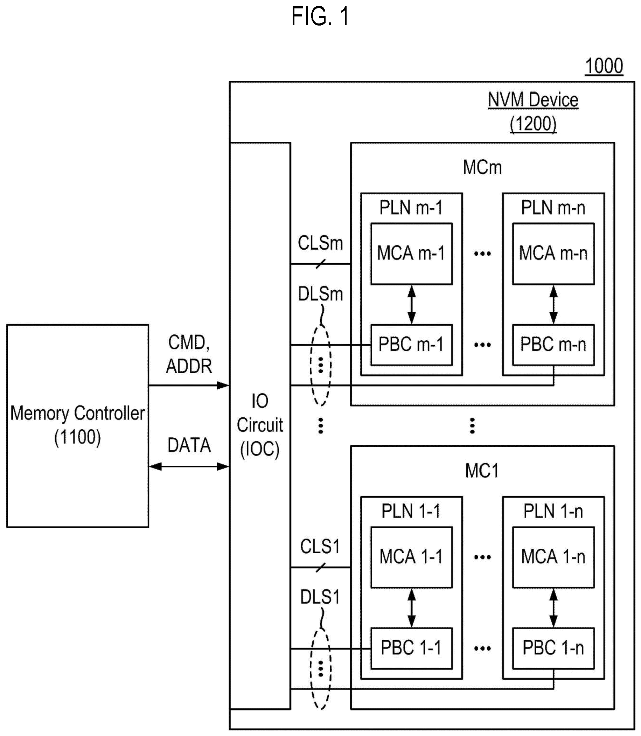

FIG. 1 is a block diagram of a memory system according to an embodiment.

Referring to FIG. 1, a memory system 1000 according to an embodiment may include a memory controller 1100 and a non-volatile memory device 1200.

The memory controller 1100 is configured to control the non-volatile memory device 1200 under control of the host or depending on an instruction from the host. For example, depending on the request of the host, the memory controller 1100 may write data in the non-volatile memory device 1200 or may read data stored in the non-volatile memory device 1200.

The memory controller 1100 may transmit a command CMD and an address ADDR to the non-volatile memory device 1200 or may exchange data "DATA" (e.g., program data or read data) with the non-volatile memory device 1200.

In an embodiment, the memory controller 1100 may be connected to the non-volatile memory device 1200 through a data line. In this case, the memory controller 1100 may transmit the command CMD and the address ADDR to the non-volatile memory device 1200 through the data line or may exchange data (e.g., program data or read data) with the non-volatile memory device 1200 through the data line.

In an embodiment, the memory controller 1100 may be connected to the non-volatile memory device 1200 through a command/address line and the data line. In this case, the memory controller 1100 may transmit the command CMD and the address ADDR to the non-volatile memory device 1200 through the command (CMD)/address (ADDR) line or may exchange with the non-volatile memory device 1200 through the data line. When the command/address line and the data line are implemented, the memory system 1000 may operate based on a separate command address (SCA) protocol.

The command CMD may be any one of a read command for requesting the reading or outputting of the data stored in the non-volatile memory device 1200 or a write command for requesting the programming or inputting of data in the non-volatile memory device 1200. In an embodiment, the command CMD may be one of various commands, such as those which are defined by the JEDEC standard or the ONFI standard, in addition to the read command and the write command.

The address ADDR may include address information corresponding to the command CMD. For example, the address information may include addresses of a column and a row of the non-volatile memory device 1200, which are to be requested or accessed by the command CMD. The row address may identify a page, a block, and a logic unit number (LUN) targeted for the access of the non-volatile memory device 1200. The column address may identify a byte or a word in the access-targeted page. For example, the address information may include an address of one or more planes, which are to be requested or accessed by the command CMD, from among a plurality of planes of the non-volatile memory device 1200.

The memory controller 1100 may generate the command CMD and may transmit the generated command CMD to the non-volatile memory device 1200. The non-volatile memory device 1200 may receive the command CMD from the memory controller 1100 and may operate based on the command CMD.

The non-volatile memory device 1200 may include a plurality of memory chips MC1 to MCm and an input/output circuit IOC.

Each of the plurality of memory chips MC1 to MCm may correspond to a die, or one or more of the plurality of memory chips MC1 to MCm may include a plurality of dies.

Each of the plurality of memory chips MC1 to MCm may include a plurality of planes and a plurality of page buffer circuits. For example, a first memory chip may include a plurality of first planes PLN1-1 to PLN1-n, and an m-th memory chip includes a plurality of m-th planes PLNm-1 to PLNm-n. For example, the plurality of first planes PLN1-1 to PLN1-n may include "n" first planes PLN1-1 to PLN1-n, and the plurality of m-th planes PLNm-1 to PLNm-n may include "n" m-th planes PLNm-1 to PLNm-n (m and n being natural numbers).

The plane is a memory unit, and each plane includes a memory cell array which includes a plurality of memory cells. For example, the (1-1)-th plane PLN1-1 includes a (1-1)-th memory cell array MCA1-1, and the (m-1)-th plane PLNm-1 includes an (m-1)-th memory cell array MCAm-1.

The memory cell array may be implemented with a plurality of blocks. The block is a memory unit and may include a plurality of pages. The block may correspond to a minimum unit of an erase operation.

In an embodiment, the plurality of page buffer circuits may be provided as much as the number of planes implemented in one memory chip. In some embodiments, the plurality of page buffer circuits may be implemented to be different in number from the plurality of planes. However, for convenience of description, in FIG. 1, it is assumed that the number of page buffer circuits is the same as the number of planes.

For example, the (1-1)-th plane PLN1-1 include a (1-1)-th page buffer circuit PBC1-1, and the (m-1)-th plane PLNm-1 include an (m-1)-th page buffer circuit PBCm-1.

Each of the plurality of page buffer circuits includes a plurality of page buffers. Each of the plurality of page buffers may operate as a write driver or a sense amplifier depending on an operation mode. For example, during the read operation including a sequential read operation and a random read operation, the page buffer may sense data stored in a selected memory cell through a bit line in the corresponding plane.

For example, during the program operation, the page buffer may transfer a bit line voltage corresponding to data (i.e., program data) to be programmed in the corresponding plane to a bit line.

In an embodiment, the page buffer may include a cache latch. In some embodiments, the page buffer may include a plurality of cache latches. Accordingly, the page buffer is capable of caching data through the cache latch. In the specification, the wording "caching" means an operation of temporarily storing data in the cache latch during a given time.

For example, during the read operation, the page buffer may output the cached data directly to the input/output circuit IOC or may output the cached data after the caching is maintained during a given time. For example, during the program operation, the page buffer may output the cached data directly to the corresponding plane or may output the cached data after the caching is maintained during the given time.

The input/output circuit IOC may receive data from the memory controller 1100 and may transfer the received data to each page buffer circuit included in each memory chip. The input/output circuit IOC may receive the data output from each page buffer circuit and may transmit the received data to the memory controller 1100.

The input/output circuit IOC is connected to the plurality of memory chips MC1 to MCm through a plurality of command input/output line sets CLS1 to CLSm and through a plurality of data input/output line sets DLS1 to DLSm. For example, the first memory chip MC1 is connected to the input/output circuit IOC through the first command input/output line set CSL1 and the first data input/output line set DLS1, and the m-th memory chip MCm is connected to the input/output circuit IOC through the m-th command input/output line set CSLm and the m-th data input/output line set DLSm.

Each of the plurality of command input/output line sets CLS1 to CLSm may include command input/output lines which allow each memory chip and each plane included in each memory chip to communicate with the input/output circuit IOC. The command input/output line transfers a command for controlling a memory chip from the input/output circuit IOC to the memory chip. Control signals for accessing the memory chip may be transferred through the command input/output line. For example, the control signals may include a control signal for word line and bit line selection of the memory chip.

In an embodiment, data associated with the status of each memory chip or each plane included in each memory chip may be output through the plurality of command input/output line sets CLS1 to CLSm. In an embodiment, a setting state of each memory chip may be output through the plurality of command input/output line sets CLS1 to CLSm.

Each of the plurality of data input/output line sets DLS1 to DLSm may include data input/output lines which allow each memory chip and each plane included in each memory chip to communicate with the input/output circuit IOC. The data input/output line is used to exchange data for a memory chip between the input/output circuit IOC and the memory chip. Data to be programmed may be provided to the page buffer circuit through the data input/output line, or the read data output from the page buffer circuit may be transferred through the data input/output line.

The data input/output lines included in one data input/output line set are connected to the plurality of page buffer circuits so as not to overlap each other. In other words, the data input/output lines included in one data input/output line set may be in a one-to-one relationship with the page buffer circuits corresponding to the one data input/output line set. For example, one of the first data input/output line set DLS1 which is connected to the first memory chip MC1 is connected to the (1-1)-th page buffer circuit PBC1-1, and another of the first data input/output line set DLS1 is connected to the (1-n)-th page buffer circuit PBC1-n. For example, one of the m-th data input/output line set DLSm which is connected to the m-th memory chip MCm is connected to the (m-1)-th page buffer circuit PBCm-1, and another of the m-th data input/output line set DLSm is connected to the (m-n)-th page buffer circuit PBCm-n.

In an embodiment, one data input/output line included in one data input/output line set may be connected to a plurality of page buffer circuits so as to overlap each other. For example, one first data input/output line included in the first data input/output line set DLS1 connected to the first memory chip MC1 may be connected to at least two or more of the plurality of first page buffer circuits PBC1-1 to PBC1-n. For example, one m-th data input/output line included in the m-th data input/output line set DLSm connected to the m-th memory chip MCm may be connected to at least two or more of the plurality of m-th page buffer circuits PBCm-1 to PBCm-n.

In an embodiment, when one data input/output line is connected to a plurality of page buffer circuits so as to overlap each other, the planes may occupy the data input/output line in time domains not overlapping each other. For example, when the first data input/output line is connected to the (1-1)-th plane PLN1-1 and the (1-2)-th plane PLN1-2, the (1-1)-th plane PLN1-1 may occupy the first data input/output line in the first time domain, and the (1-2)-th plane PLN1-2 may occupy the first data input/output line in the second time domain.

In an embodiment, commands are transmitted through the plurality of command input/output line sets CLS1 to CLSm for each of the plurality of memory chips MC1 to MCm and for each of the plurality of planes. Accordingly, each memory chip and each plane may be controlled independently of each other.

In an embodiment, at least some of command transmission operations for each of the plurality of memory chips MC1 to MCm and for each of the plurality of planes may overlap each other on the time domain. In other words, command transmission periods for each of the plurality of memory chips MC1 to MCm and for each of the plurality of planes may fully overlap each other or only some thereof may overlap each other (i.e., the transmission periods may be mutually interleaved).

In an embodiment, the command transmission periods for each of the plurality of memory chips MC1 to MCm and for each of the plurality of planes may be interleaved without overlapping each other.

According to various embodiments, since commands are transmitted for each of the plurality of memory chips MC1 to MCm and for each of the plurality of planes, core operations may be performed for each of the plurality of memory chips MC1 to MCm and for each of the plurality of planes. The core operation may refer to one or more operations performed in a page buffer circuit for the read operation or program operation according to the command. For example, the above caching by the cache latch is included in the core operation.

According to various embodiments, because the command input/output line included in the plurality of command input/output line sets CLS1 to CLSm and the data input/output line included in the plurality of data input/output line sets DLS1 to DLSm are individually connected to a memory chip and a plane, the core operations may be performed on the plurality of memory chips MC1 to MCm and the plurality of planes so as to overlap each other.

For example, when the command corresponding to the first memory chip MC1 (and the plurality of first planes PLN1-1 to PLN1-n) and the m-th memory chip MCm (and the plurality of m-th planes PLNm-1 to PLNm-n) indicates the read operation, the plurality of first page buffer circuits PBC1-1 to PBC1-n may cache the data stored in the plurality of first memory cell arrays MCA1-1 to MCA1-n and transmit the cached data to the input/output circuit IOC. The plurality of m-th page buffer circuits PBCm-1 to PBCm-n may cache the data stored in the plurality of m-th memory cell arrays MCAm-1 to MCAm-n and transmit the cached data to the input/output circuit IOC. In this case, the caching operations for the data read from the plurality of first planes PLN1-1 to PLN1-n and the data read from the plurality of m-th planes PLNm-1 to PLNm-n may be performed in parallel. For example, the caching operations for the data read from the plurality of first planes PLN1-1 to PLN1-n and the data read from the plurality of m-th planes PLNm-1 to PLNm-n may be performed at the same time. That is, the core operations for read data may be performed on memory chips and planes so as to overlap each other.

For example, when the command corresponding to the first memory chip MC1 (and the plurality of first planes PLN1-1 to PLN1-n) and the m-th memory chip MCm (and the plurality of m-th planes PLNm-1 to PLNm-n) indicates the program operation, the plurality of first page buffer circuits PBC1-1 to PBC1-n may cache the program data received from the input/output circuit IOC and transmit the cached data to the plurality of first memory cell arrays MCA1-1 to MCA1-n. The plurality of m-th page buffer circuits PBCm-1 to PBCm-n may cache the program data received from the input/output circuit IOC and transmit the cached data to the plurality of m-th memory cell arrays MCAm-1 to MCAm-n. In this case, the caching operations for the data to be programmed in the plurality of first planes PLN1-1 to PLN1-n and the data to be programmed in the plurality of m-th planes PLNm-1 to PLNm-n may be performed in parallel. For example, the caching operations for the data to be programmed in the plurality of first planes PLN1-1 to PLN1-n and the data to be programmed in the plurality of m-th planes PLNm-1 to PLNm-n may be performed at the same time. That is, the core operations for program data may be performed on memory chips and planes so as to overlap each other.

For example, when the command corresponding to the first memory chip MC1 (and the plurality of first planes PLN1-1 to PLN1-n) indicates the read operation and the m-th memory chip MCm (and the plurality of m-th planes PLNm-1 to PLNm-n) indicates the program operation, the plurality of first page buffer circuits PBC1-1 to PBC1-n may cache the data stored in the plurality of first memory cell arrays MCA1-1 to MCA1-n and transmit the cached data to the input/output circuit IOC. The plurality of m-th page buffer circuits PBCm-1 to PBCm-n may cache the program data received from the input/output circuit IOC and transmit the cached data to the plurality of m-th memory cell arrays MCAm-1 to MCAm-n. In this case, the caching operations for the data read from the plurality of first planes PLN1-1 to PLN1-n and the data to be programmed in the plurality of m-th planes PLNm-1 to PLNm-n may be performed in parallel. For example, the caching operations for the data read from the plurality of first planes PLN1-1 to PLN1-n and the data to be programmed in the plurality of m-th planes PLNm-1 to PLNm-n may be performed at the same time. That is, the core operations for read data and program data may be performed on memory chips and planes so as to overlap each other.

In the non-volatile memory device 1200 according to the above embodiment illustrated with respect to FIG. 1, the command input/output line and the data input/output line may be provided for each of the plurality of memory chips MC1 to MCm, and the command input/output line and the data input/output line may be provided for each of the plurality of planes in the same memory chip. Accordingly, the core operations for respective planes such as the caching operation may be performed in parallel (i.e., the core operations for respective planes may overlap each other) through the input/output line provided for each memory chip and for each plane. This configuration and operation may mean that the core performance of the non-volatile memory device 1200 is improved as much as the number of memory chips.

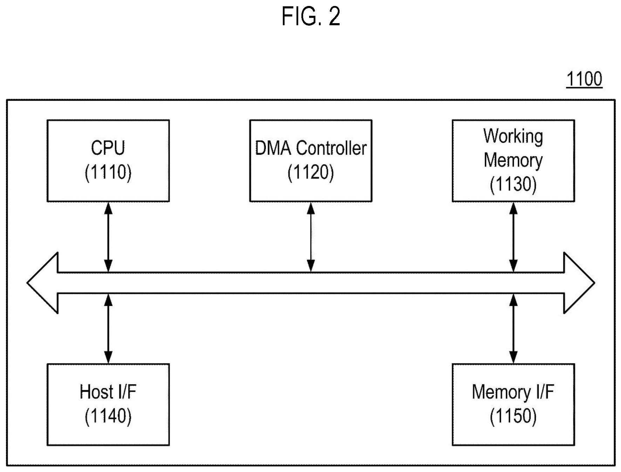

FIG. 2 is a block diagram of a memory controller of FIG. 1 according to some example embodiments.

Referring to FIG. 2, the memory controller 1100 according to some example embodiments may include a central processing unit (CPU) 1110, a direct memory access (DMA) controller 1120, a working memory 1130, a host interface (I/F) 1140, and a memory interface (I/F) 1150.

In an embodiment, the CPU 1110 may drive firmware which is executable in the memory controller 1100. For example, the CPU 1110 may drive various firmware or software loaded to the working memory 1130. In some embodiments, the CPU 1110 may execute firmware or software, which takes charge of functions of a storage device, such as a host interface layer (HIL) or a flash interface layer (FIL).

The CPU 1110 may generate, manage, or process a command, an address, and/or data according to an embodiment of the present disclosure. In an embodiment, the CPU 1110 may generate a command and an address for each memory chip and plane.

In an embodiment, the CPU 1110 may control the memory interface 1150 such that a command and an address are applied in parallel for each memory chip and plane of the non-volatile memory device (refer to FIG. 1) or may control the memory interface 1150 such that a command and an address are interleaved for each memory chip and plane of the non-volatile memory device.

In some embodiments, the CPU 1110 may include a plurality of cores. Each of the plurality of cores may be implemented with an independent processor core. The plurality of cores may include a host core, a flash translation layer (FTL) core, and/or a NAND core.

The host core may be defined as an internal core of the memory system (refer to FIG. 1), which performs an HIL-related operation. For example, the host core may process a request received from the host through the host interface 1140.

The FTL core may be defined as an internal core of the memory system, which performs an FTL-related operation. For example, the FTL core may control the NAND core based on the request received from the host core such that the read operation, the write operation, or the erase operation is performed in the non-volatile memory device. In some embodiments, by using the FTL, the FTL core may perform an address mapping operation such that a logical block address (LBA) transmitted from the host is mapped to a physical block address (PBA) being a physical location of the non-volatile memory device.

The NAND core may be defined as an internal core of the memory system, which performs an FTL-related operation. For example, under control of the FTL core, the NAND core may control the memory interface 1150 such that operations of the non-volatile memory device are performed.

Data or software (or firmware) for controlling the memory controller 1100 is loaded to the working memory 1130. The software and data loaded to the working memory 1130 are driven or processed by the CPU 1110. A flash translation layer which is driven by the CPU 1110 performs functions such as an address managing function, a garbage collection function, and a wear-leveling function. For example, the working memory 1130 may include a DRAM and/or an SRAM.

The host interface (I/F) 1140 provides an interface between the host and the memory controller 1100. The host and the memory controller 1100 may be connected through one of various standardized interfaces. Herein, the standardized interfaces may include various interfaces such as an advanced technology attachment (ATA) interface, a serial ATA (SATA) interface, an external SATA (e-SATA) interface, a small computer small interface (SCSI), a serial attached SCSI (SAS), a peripheral component interconnection (PCI) interface, a PCI Express (PCI-E) interface, a universal serial bus (USB) interface, an IEEE 1394 interface, a universal flash store (UFS^{™}) interface, and/or a card interface.

The memory interface (I/F) 1150 provides interfacing between the memory controller 1100 and the non-volatile memory device. For example, the data processed by the CPU 1110 may be stored in the non-volatile memory device through the memory interface 1150, or the data read from the non-volatile memory device may be transferred to the memory controller 1100 through the memory interface 1150.

In an embodiment, the memory controller 1100 may further include a read only memory (ROM), which stores code data necessary for a booting operation, or an error correction code (ECC) block, in addition to the above components.

In an embodiment, the memory controller 1100 may further include the DMA controller 1120. The DMA controller 1120 may control data transmission between the working memory 1130 and the non-volatile memory device.

For example, the DMA operation may be performed in units of plane. In this case, the data stored in the non-volatile memory device may be transmitted to the working memory 1130 in units of plane, or the data stored in the working memory 1130 may be transmitted to the non-volatile memory device in units of plane. However, this operation is provided as an example, and the present disclosure is not limited thereto. According to an embodiment, the DMA operation may be performed in units of block smaller than the plane.

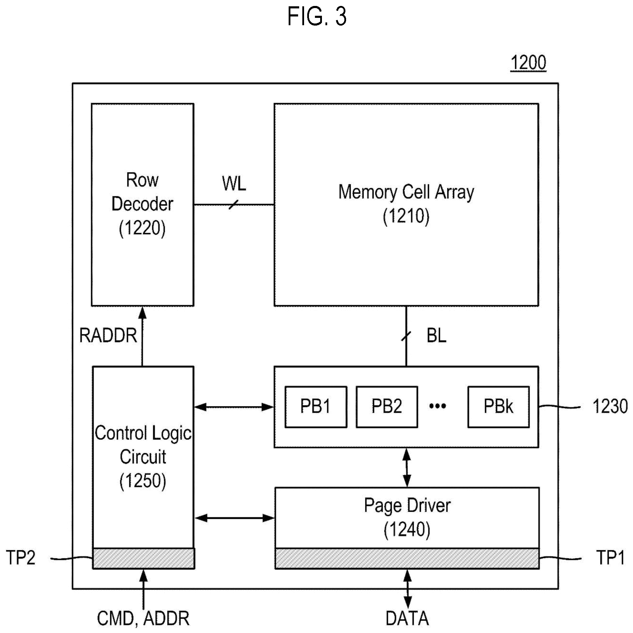

FIG. 3 is a block diagram of a non-volatile memory device corresponding to a plane, according to an embodiment.

Referring to FIG. 3, the non-volatile memory device 1200 may include a memory cell array 1210, a row decoder 1220, a page buffer circuit 1230, a page buffer driver 1240, and a control logic circuit 1250. The row decoder 1220, the page buffer circuit 1230, the page buffer driver 1240, and the control logic circuit 1250 are included in a peripheral circuit.

The memory cell array 1210 may be connected to the page buffer circuit 1230 through bit lines BL and may be connected to the row decoder 1220 through word lines WL.

The memory cell array 1210 may include a plurality of memory blocks. Each of the plurality of memory blocks may include a plurality of memory cells. For example, each of the plurality of memory cells may be a single level cell (SLC), a multi-level cell (TLC), a triple level cell (TLC), a quad level cell (QLC), or a memory cell having a greater level than the QLC.

For example, the memory cell array 1210 may have a two-dimensional structure (or horizontal structure) or a three-dimensional structure (or vertical structure). In the two-dimensional structure, the memory cell array 1210 may be arranged or formed along a substrate in a second direction D2. In the three-dimensional structure, the memory cell array 1210 may be stacked along the substrate in a first direction D1.

In an embodiment, the memory cell array 1210 may include a three-dimensional memory cell array. The three-dimensional memory cell array may be formed of a plurality of levels and may include word lines or bit lines which are shared between levels.

The row decoder 1220 may select one of the word lines WL connected to the memory cell array 1210 in response to a row address RADDR. As the word line is selected, a page corresponding to the word line is selected.

The page buffer circuit 1230 may include a plurality of page buffers PB1 to PBk. The plurality of page buffers PB1 to PBk may be respectively connected to memory cells through the bit lines BL. The page buffer circuit 1230 may select at least one of the bit lines BL in response to a column address provided from the control logic circuit 1250.

Each of the plurality of page buffers PB1 to PBk may include a cache latch and may be capable of caching data through the cache latch.

The page buffer driver 1240 is connected to the page buffer circuit 1230.

In an embodiment, the page buffer driver 1240 is connected to a first TSV pad TP1. The page buffer driver 1240 may receive/output the data "DATA" through the first TSV pad TP1. The page buffer driver 1240 inputs the data "DATA" received from the first TSV pad TP1 to the page buffer circuit 1230 or outputs the data "DATA" received from the page buffer circuit 1230 to the first TSV pad TP1.

The control logic circuit 1250 may control all operations of the non-volatile memory device 1200. The control logic circuit 1250 may output various kinds of control signals for programming data in the memory cell array 1210, reading data from the memory cell array 1210, or erasing data stored in the memory cell array 1210 in response to the command CMD and/or the address ADDR. The control logic circuit 1250 may include individual processing tasks (or threads) for performing various memory access operations (e.g., a read operation, a program operation, and an erase operation).

In an embodiment, the control logic circuit 1250 is connected to a second TSV pad TP2. The control logic circuit 1250 may receive the command CMD and the address ADDR through the second TSV pad TP2. The control logic circuit 1250 may control a plane based on the command CMD and the address ADDR received through the second TSV pad TP2.

The non-volatile memory device 1200 according to the above embodiment illustrated with respect to FIG. 3 is capable of receiving the command through the second TSV pad TP2 and performing data input/output through the first TSV pad TP1 for each plane, and thus, the non-volatile memory device 1200 is capable of performing the core operations of planes in parallel, for example as described elsewhere herein in more detail.

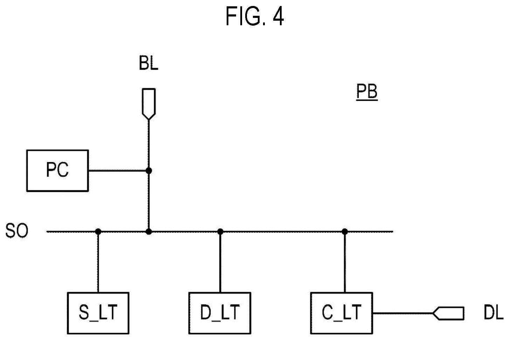

FIG. 4 is a block diagram of a page buffer according to an embodiment.

Referring to FIG. 4, a page buffer PB according to an embodiment may be connected to a bit line BL. The page buffer PB may include a sensing node SO connected to the bit line BL. The page buffer PB may include a precharge circuit PC and a plurality of latches S_LT, D_LT, and C_LT, each of which is connected to the sensing node SO.

The precharge circuit PC may precharge the bit line BL with any one of a program permission voltage or a program inhibition voltage under control of the control logic circuit.

The sensing latch S_LT among the latches S_LT, D_LT, and C_LT may store data sensed through the bit line BL. Also, the sensing latch S_LT may store precharge data to be used to determine the precharge voltage.

The data latch D_LT among the latches S_LT, D_LT, and C_LT may store data to be programmed in a memory cell. In an embodiment, the data latch D_LT may be implemented with a plurality of data latches depending on a level of a memory cell.

The cache latch C_LT among the latches S_LT, D_LT, and C_LT may be connected to a data input/output line DL. In an embodiment, the cache latch C_LT may cache the data received through the data input/output line DL. In some embodiments, the cache latch C_LT may cache data to be transmitted to the data input/output line DL. In an embodiment, the cache latch C_LT may be implemented with a plurality of cache latches.

The page buffer PB may cache data through the cache latch C_LT. That is, the page buffer PB may cache the read data according to the read command in the cache latch C_LT without outputting the read data through the data input/output line DL immediately after receiving the read data or may cache the program data according to the program command in the cache latch C_LT without outputting the program data through the bit line BL immediately after receiving the program data.

Accordingly, the non-volatile memory device including the page buffer PB is capable of operating in an asynchronous interleaving manner for memory chips and planes, rather than in a synchronous interleaving manner.

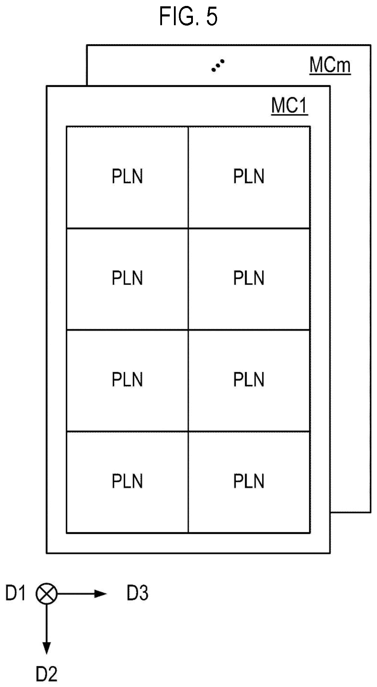

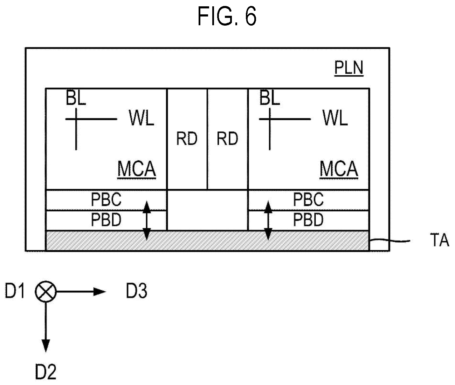

FIG. 5 is a block diagram of a plurality of memory chips and planes of each memory chip, according to an embodiment. FIG. 6 is a block diagram of a plane included in one memory chip of FIG. 5, according to an embodiment.

Referring to FIGS. 5 and 6, the plurality of memory chips MC1 to MCm according to an embodiment are stacked along the first direction D1. Each of the plurality of memory chips MC1 to MCm includes a plurality of planes PLN. The number of planes PLN included in one memory chip may be variously defined or implemented according to embodiments. The case where eight planes PLN are included in one memory chip is illustrated in FIG. 5, but embodiments of the present disclosure are not limited thereto. The plurality of planes PLN may be arranged along the second direction D2 and/or may be arranged along a third direction D3.

Each plane PLN may include a plurality of memory blocks. In an embodiment, the plurality of memory blocks may include at least one of an SLC block including the above SLCs, a multi-level cell block including the above MLCs, a triple level cell block including the above TLCs, or a quad level cell block including the above QLCs. In an embodiments, some of the plurality of memory blocks may be SLC blocks, and the others thereof may be MLC blocks, TLC, blocks or QLC blocks.

As illustrated in FIG. 6, one plane PLN may include a plurality of memory cell arrays MCA connected to the word line WL and the bit line BL, a plurality of page buffer circuits PBC, a plurality of page buffer drivers PBD, a plurality of row decoders RD, and a through silicon via (TSV) area TA. To control and access one memory cell array MCA, the page buffer circuit PBC, the page buffer driver PBD, and the row decoder RD are provided for each of the plurality of memory cell arrays MCA.

Accordingly, each of the plurality of memory chips MC1 to MCm includes the plurality of planes PLN, each of the plurality of planes PLN includes the memory cell arrays MCA and the plurality of page buffer circuits PBC, and each of the plurality of page buffer circuits PBC includes the cache latch (for example as described above with reference to Fig. 4) that caches the data sensed from the corresponding memory cell array MCA.

The page buffer circuit PBC caches data for the corresponding memory cell array MCA. The page buffer driver PBD controls the input/output of data to be provided to the page buffer circuit PBC or the input/output of data provided from the page buffer circuit PBC. The row decoder RD is configured to select the word line WL connected to the memory cell array MCA based on a command and an address. Data stored at a page corresponding to the selected word line are dumped to the page buffer circuit PBC through the bit line BL, and the data of the page buffer circuit PBC are programmed at the selected page through the bit line BL.

In the above embodiments, for convenience of description, the connection relationship between the page buffer circuit PBC, the page buffer driver PBD, and the memory cell array MCA is provided only as an example. According to various embodiments, the page buffer circuit PBC and the page buffer driver PBD may be disposed at various locations capable of being connected to the memory cell array MCA.

The TSV area TA is implemented along the third direction D3 in which the word line WL extends. The TSV area TA is defined as an area which penetrates the plurality of memory chips MC1 to MCm along the first direction D1 and includes a plurality of through vias. For example, the TSV area TA may be an area of the plurality of memory chips MC1 to MCm along the first direction D1 that includes the plurality of through vias. The plurality of through vias correspond to a plurality of input/output lines for command and data communication. Accordingly, the page buffer circuit PBC and the page buffer driver PBD process data which are transmitted/received through the TSV area TA.

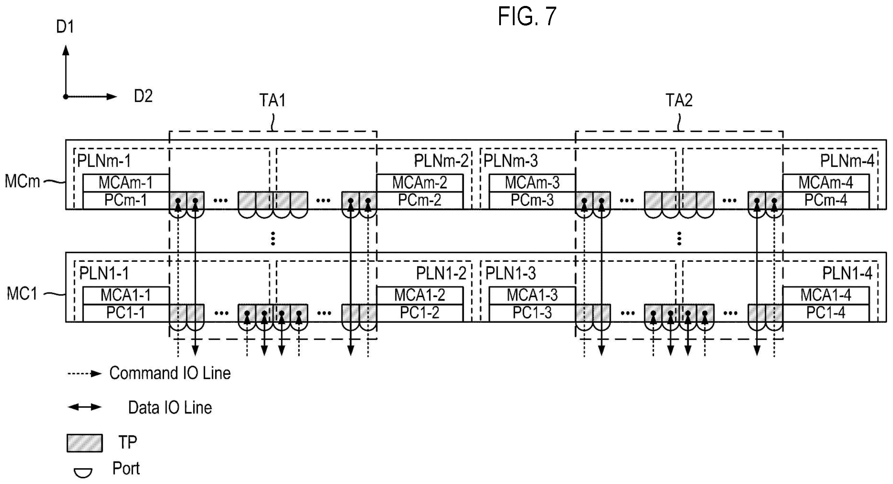

FIG. 7 illustrates a plurality of memory chips included in a non-volatile memory device, according to an embodiment.

Referring to FIG. 7, the plurality of memory chips MC1 to MCm according to an embodiment include the first to m-th memory chips MC1 to MCm. Herein, "m" is a natural number of 2 or more. For example, the m-th memory chip MCm is stacked on the first memory chip MC1 along the first direction D1. Below, in each memory chip, the number of planes, the number of memory cell arrays, and the number of peripheral circuits are provided as an example, and embodiments of the present disclosure are not limited thereto.

Each of the plurality of memory chips MC1 to MCm includes a TSV area. For example, in the case of FIG. 7, a first TSV area TA1 and a second TSV area TA2 are provided in each memory chip.

In an embodiment, in each of the plurality of memory chips MC1 to MCm, the first TSV area TA1 and the second TSV area TA2 may be provided between two planes that are adjacent to each other along the second direction D2 and that are provided not to overlap each other in the second direction D2. For example, the first TSV area TA1 is provided between the (1-1)-th plane PLN1-1 and the (1-2)-th plane PLN1-2 along the second direction D2, and the first TSV area TA1 is provided between the (m-1)-th plane PLNm-1 and the (m-2)-th plane PLNm-2. The second TSV area TA2 is provided between the (1-3)-th plane PLN1-3 and the (1-4)-th plane PLN1-4 along the second direction D2, and the second TSV area TA2 is provided between the (m-3)-th plane PLNm-3 and the (m-4)-th plane PLNm-4.

A plurality of TSV pads TP and a plurality of ports are provided in the TSV area. For example, the plurality of ports may be micro ports. A through via may be connected to each of the plurality of TSV pads TP and the plurality of ports. Each memory chip may receive a command by using the through via and may exchange data by using the through via.

A plurality of command input/output lines and a plurality of data input/output line are provided in the TSV area. Each of the input/output lines provided in the TSV area includes a line which is connected between the through via in the TSV area and components to which a signal being exchanged through the input/output line is to be provided.

In an embodiment, the plurality of command input/output lines are provided for each of different memory chips and planes. Likewise, the plurality of data input/output lines are provided for each of different memory chips and planes. To provide the input/output line for each memory chip and plane, one input/output line may include a line which is connected to the through via and corresponds to one plane in one memory chip. Also, the TSV pad TP and the port are provided for every type of the input/output line (e.g., every command input/output line and every data input/output line).

Each of the plurality of memory chips MC1 to MCm includes a plurality of planes. For example, the first memory chip MC1 includes the plurality of first planes PLN1-1 to PLN1-4, each including a first memory cell array MCA1 and a first peripheral circuit PC1, and the m-th memory chip MCm includes the plurality of m-th planes PLNm-1 to PLNm-4, each including an m-th memory cell array MCAm and an m-th peripheral circuit PCm.

Each of the plurality of peripheral circuits may include components, which control and access the memory cell array, such as a page buffer circuit, a page buffer driver, and a control logic circuit. The page buffer circuit includes a cache latch capable of providing the caching operation according to the above embodiments illustrated with respect to FIGS. 1-7.

In an embodiment, the memory cell array included in each memory chip may be stacked on the peripheral circuit along the first direction D1. For example, the (1-1)-th memory cell array MCA1-1 may be stacked on the (1-1)-th peripheral circuit PC1-1 along the first direction D1. However, this configuration is provided only as an example embodiment, and embodiments of the present disclosure are not limited thereto. That is, In an embodiment, the peripheral circuit may be provided under the memory cell array when viewed in the first direction D1 and may be provided at various locations in one plane, at which it is possible to control the memory cell array and/or to communicate with the memory cell array.

Each of the plurality of peripheral circuits PC is connected to the command input/output line and the data input/output line (i.e., the through via) through the corresponding TSV pad TP. For example, in the first memory chip MC1, the (1-1)-th peripheral circuit PC1-1 is connected to the corresponding input/output lines, that is, the first command input/output line and the first data input/output line through the TSV pad TP, and the (1-2)-th peripheral circuit PC1-2 is connected to the corresponding input/output lines, that is, the first command input/output line and the first data input/output line through the TSV pad TP. Accordingly, in the same memory chip, different peripheral circuits are capable of performing the caching operations on different planes (and memory cell arrays).

For example, the plurality of first peripheral circuits PC1-1 to PC1-4 included in the first memory chip MC1 and the plurality of m-th peripheral circuits PCm-1 to PCm-4 included in the m-th memory chip MCm are connected to different command input/output lines and different data input/output lines through different TSV pads TP. Accordingly, different peripheral circuits are capable of performing the caching operations on different planes (and memory cell arrays) between memory chips.

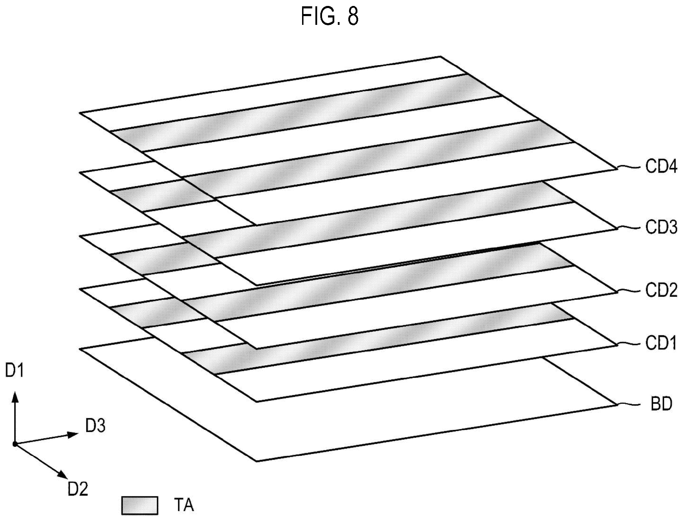

FIG. 8 illustrates a non-volatile memory device according to an embodiment.

Referring to FIG. 8, for convenience of description, an embodiment in which a plurality of core dies CD1 to CD4 are stacked is illustrated, but embodiments of the present disclosure are not limited thereto. The non-volatile memory device according to an embodiment may include a memory stack which includes a base die BD and the first to fourth core dies CD1 to CD4.

The base die BD may be configured to receive a command, an address, and data from the host and to perform the access and control on the memory stack based on the received command, address, and data. An input/output circuit which performs the input/output operation on the memory stack may be provided on the base die BD.

In an embodiment, the base die BD includes the input/output circuit. The input/output circuit is provided in the TSV area TA that penetrates the plurality of memory chips along the first direction D1 and that is configured to communicate with the plurality of memory chips through the data input/output line connected to the peripheral circuit PC for each of the plurality of planes.

The first to fourth core dies CD1 to CD4 are sequentially stacked on the base die BD along the first direction D1. Each of the first to fourth core dies CD1 to CD4 may include the TSV area TA. In one core die, the remaining area other than the TSV area TA may be a memory cell area.

Because the core die corresponds to the memory chip, the plurality of memory chips are sequentially stacked on the base die BD along the first direction D1.

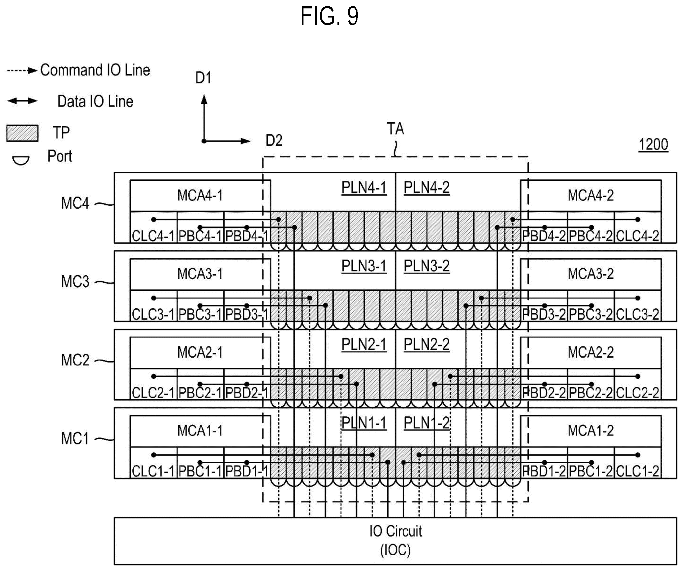

FIG. 9 illustrates a non-volatile memory device according to an embodiment.

Referring to FIG. 9, for convenience of description, an embodiment in which four memory chip MC1 to MC4 among the plurality of memory chips MC1 to MCm are stacked is illustrated, but embodiments of the present disclosure are not limited thereto. The non-volatile memory device 1200 according to an embodiment includes a first memory chip MC1, a second memory chip MC2, a third memory chip MC3, and a fourth memory chip MC4 and the input/output circuit IOC.

The first to fourth memory chips MC1 to MC4 are sequentially stacked along the first direction D1. In an embodiment, each memory chip may correspond to a core die of FIG. 8. Also, the input/output circuit IOC may be implemented in the base die BD of FIG. 8.

The first memory chip MC1 include a plurality of first planes PLN1-1 and PLN1-2. The first plane PLN1-1 includes the first memory cell array MCA1-1, the first page buffer circuit PBC1-1 including a first cache latch that caches the data sensed from the first memory cell array MCA1-1, the first page driver PBD1-1, and the first logic circuit CLC1-1, and the first plane PLN1-2 includes the first memory cell array MCA1-2, the first page buffer circuit PBC1-2 including a first cache latch that caches the data sensed from the first memory cell array MCA 1-2, the first page driver PBD1-2, and the first logic circuit CLC1-2. The second memory chip MC2 is stacked on the first memory chip MC1 along the first direction D1. The second memory chip MC2 includes a plurality of second planes PLN2-1 and PLN2-2. The second plane PLN2-1 includes the second memory cell array MCA2-1, the second page buffer circuit PBC2-1 including a second cache latch that caches the data sensed from the second memory cell array MCA2-1, the second page driver PBD2-1, and the second logic circuit CLC2-1, and the second plane PLN2-2 includes the second memory cell array MCA2-2, the second page buffer circuit PBC2-2 including a second cache latch that caches the data sensed from the second memory cell array MCA2-2 the second page driver PBD2-2, and the second logic circuit CLC2-2.

The third memory chip MC3 is stacked on the second memory chip MC2 along the first direction D1. The third memory chip MC3 includes a plurality of third planes PLN3-1 and PLN3-2. The third plane PLN3-1 includes the third memory cell array MCA3-1, the third page buffer circuit PBC3-1 including a third cache latch that caches the data sensed from the third memory cell array MCA3-1, the third page driver PBD3-1, and the third logic circuit CLC3-1, and the third plane PLN3-2 includes the third memory cell array MCA3-2, the third page buffer circuit PBC3-2 including a third cache latch that caches the data sensed from the third memory cell array MCA3-2, the third page driver PBD3-2, and the third logic circuit CLC3-2. The fourth memory chip MC4 is stacked on the third memory chip MC3 along the first direction D1. The fourth memory chip MC4 includes a plurality of fourth planes PLN4-1 and PLN4-2. The fourth plane PLN4-1 includes the fourth memory cell array MCA4-1, the fourth page buffer circuit PBC4-1 including a fourth cache latch that caches the data sensed from the fourth memory cell array MCA4-1, the fourth page driver PBD4-1, and the fourth logic circuit CLC4-1, and the fourth plane PLN4-2 includes the fourth memory cell array MCA4-2, the fourth page buffer circuit PBC4-2 including a fourth cache latch that caches the data sensed from the fourth memory cell array MCA4-2, the fourth page driver PBD4-2, and the fourth logic circuit CLC4-2.

The control logic circuit included in each of the plurality of planes is configured to receive a command for accessing the memory cell array through the command input/output line and to control each of the plurality of planes based on the command. The control logic circuit controls all operations of components associated with or included in one plane in the memory chip.

The first control logic circuits CLC1-1 and CLC1-2 are configured to receive the first command for accessing the first memory cell arrays MCA1-1 and MCA1-2 through the first command input/output lines and to control the plurality of first planes PLN1-1 and PLN1-2 based on the first command. The second control logic circuits CLC2-1 and CLC2-2 are configured to receive the second command for accessing the second memory cell arrays MCA2-1 and MCA2-2 through the second command input/output lines and to control the plurality of second planes PLN2-1 and PLN2-2 based on the second command.

The third control logic circuits CLC3-1 and CLC3-2 are configured to receive the third command for accessing the third memory cell arrays MCA3-1 and MCA3-2 through the third command input/output lines and to control the plurality of third planes PLN3-1 and PLN3-2 based on the third command. The fourth control logic circuits CLC4-1 and CLC4-2 are configured to receive the fourth command for accessing the fourth memory cell arrays MCA4-1 and MCA4-2 through the fourth command input/output lines and to control the plurality of fourth planes PLN4-1 and PLN4-2 based on the fourth command.

The input/output circuit IOC is connected in the TSV area TA to the command input/output line and to the data input/output line connected for each of the plurality of planes.

The input/output circuit IOC is configured to communicate with the first memory chip MC1 through the first command input/output lines and the first data input/output lines, to communicate with the second memory chip MC2 through the second command input/output lines and the second data input/output lines, to communicate with the third memory chip MC3 through the third command input/output lines and the third data input/output lines, and to communicate with the fourth memory chip MC4 through the fourth command input/output lines and the fourth data input/output lines.

In an embodiment, the first command input/output line and the first data input/output line are provided in the TSV area TA that penetrates the first memory chip MC1, the second memory chip MC2, the third memory chip MC3, and the fourth memory chip MC4, and are connected to the corresponding plane among the plurality of first planes PLN1-1 and PLN1-2. The second command input/output line and the second data input/output line are provided in the TSV area TA and are connected to the corresponding plane among the plurality of second planes PLN2-1 and PLN2-2. The third command input/output line and the third data input/output line are provided in the TSV area TA and are connected to the corresponding plane among the plurality of third planes PLN3-1 and PLN3-2. The fourth command input/output line and the fourth data input/output line are provided in the TSV area TA and are connected to the corresponding plane among the plurality of fourth planes PLN4-1 and PLN4-2.

Since each command input/output line and each data input/output line are connected for the corresponding memory chip and plane, the input/output circuit IOC is capable of performing command and data input/output for each memory chip and plane. Also, each control logic circuit is capable of controlling the page buffer circuit and the page buffer driver depending on the command applied individually or independently.

In an embodiment, the input/output circuit IOC may perform operations of transmitting commands to the control logic circuits through the command input/output lines in parallel in association with the plurality of memory chips MC1 to MCm and the plurality of planes.

The connection with each command input/output line/data input/output line is made by using the through via connected to the TSV pad TP and the port provided on the TSV area TA. Accordingly, the command transferred from the input/output circuit IOC is provided to the control logic circuit through the command input/output line (and the through via). Also, data which are input/output through the input/output circuit IOC are provided to the page buffer circuit and the page buffer driver through the data input/output line (and the through via). In the process of transferring data, each page buffer circuit is capable of caching the data.

In some embodiments, unlike the embodiment of FIG. 9, one data input/output line may be connected to two or more page buffer circuits. That is, two or more page buffer circuits may share one data input/output line. For example, in the first memory chip MC1, the (1-1)-th page buffer circuit PBC1-1 and the (1-2)-th page buffer circuit PBC1-2 may be connected to one fist data input/output line. In this case, one first data input/output line may transfer the cached data to respective page buffer circuits in different time domains or may transfer data to respective page buffer circuits in different time domains.

For convenience, the description is above given based on an example in which each data input/output line is connected to a corresponding page buffer circuit as illustrated in FIG. 9, but embodiments of the present disclosure are not limited thereto.

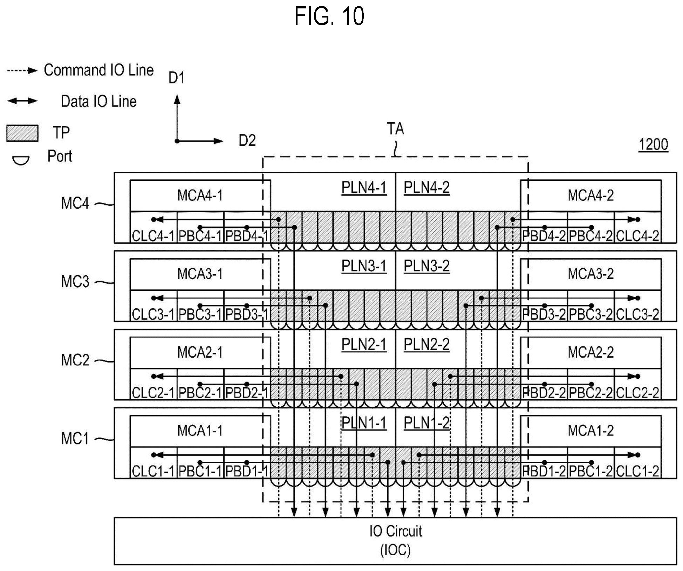

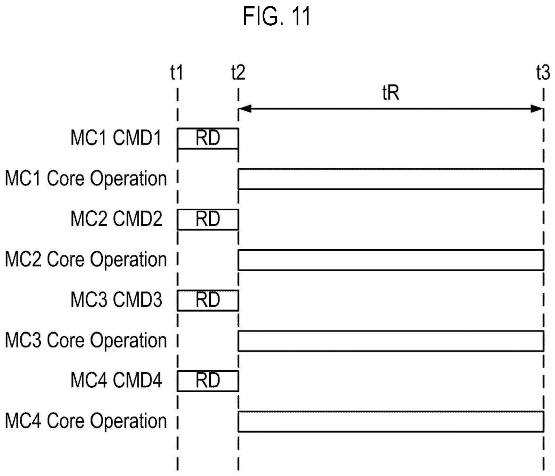

FIG. 10 illustrates a read operation of a non-volatile memory device according to an embodiment, and FIG. 11 illustrates how a read command is applied to a non-volatile memory device and how the non-volatile memory device performs core operations, according to an embodiment.

Referring to FIGS. 10 and 11, at a time point t1, read commands RD are applied to the first to fourth memory chips MC1 to MC4. During a time interval from t1 to t2 in which the read commands RD are applied, the input/output circuit IOC transmits a first command CMD1 to the first memory chip MC1 through a first command (CMD1) input/output line, transmits a second command CMD2 to the second memory chip MC2 through a second command (CMD2) input/output line, transmits a third command CMD3 to the third memory chip MC3 through a third command (CMD3) input/output line, and transmits a fourth command CMD4 to the fourth memory chip MC4 through a fourth command (CMD4) input/output line.

According to embodiments, the input/output circuit IOC performs the following operations in parallel: an operation of transmitting the first command CMD1 to the first control logic circuit CLC1-1/CLC1-2 through the first command (CMD1) input/output line, an operation of transmitting the second command CMD2 to the second control logic circuit CLC2-1/CLC2-2 through the second command (CMD2) input/output line, an operation of transmitting the third command CMD3 to the third control logic circuit CLC3-1/CLC3-2 through the third command (CMD3) input/output line, and an operation of transmitting the fourth command CMD4 to the fourth control logic circuit CLC4-1/CLC4-2 through the fourth command (CMD4) input/output line. Accordingly, the operations of applying the read command RD through respective command input/output lines may be simultaneously performed in parallel.

That is, the input/output circuit IOC may transmit commands for a plurality of planes in parallel through command input/output lines which are provided in the TSV area TA and are connected for respective planes.

Each control logic circuit controls the core operation for each memory chip based on the command indicating the read operation. For example, based on the first command CMD1 indicating the read operation, the first control logic circuit CLC1-1/CLC1-2 controls the first page buffer circuit PBC1-1/PBC1-2 such that data stored in the first memory cell array MCA1-1/MCA1-2 are dumped to the first cache latch. Based on the second command CMD2 indicating the read operation, the second control logic circuit CLC2-1/CLC2-2 controls the second page buffer circuit PBC2-1/PBC2-2 such that data stored in the second memory cell array MCA2-1/MCA2-2 are dumped to the second cache latch.

Based on the third command CMD3 indicating the read operation, the third control logic circuit CLC3-1/CLC3-2 controls the third page buffer circuit PBC3-1/PBC3-2 such that data stored in the third memory cell array MCA3-1/MCA3-2 are dumped to the third cache latch. Based on the fourth command CMD4 indicating the read operation, the fourth control logic circuit CLC4-1/CLC4-2 controls the fourth page buffer circuit PBC4-1/PBC4-2 such that data stored in the fourth memory cell array MCA4-1/MCA4-2 are dumped to the fourth cache latch.

Since the page buffer circuit is controlled through each control logic circuit, during tR which is defined as a page read time and is between a time point t2 and a time point t3, the core operations of the memory chips including the dumping to the first to fourth cache latches may be performed in parallel.

The first to fourth cache latches cache the dumped data. The first to fourth cache latches transmit the cached data to the input/output circuit IOC under control of the control logic circuits.

The non-volatile memory device 1200 according to the above embodiment illustrated with respect to FIGS. 10-11 may perform the core operations in parallel through input/output lines provided for each memory chip and plane. Accordingly, as memory chips are stacked, the performance of the core operation may be improved.

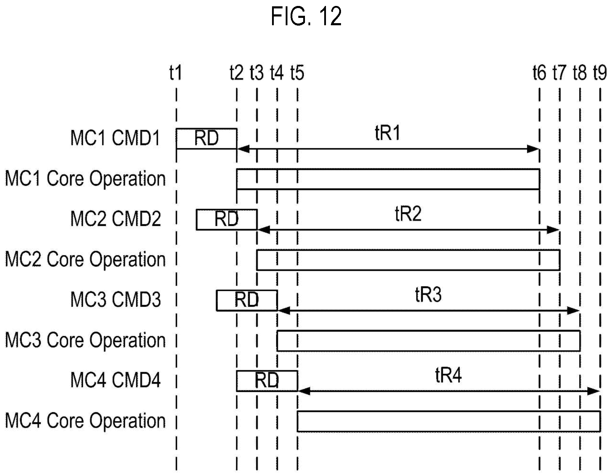

FIG. 12 illustrates how to interleave the read commands RD to the non-volatile memory device 1200 and how to perform the core operations based on the read commands RD, according to an embodiment.

Referring to FIGS. 10 and 12, at a time interval from t1 to t5, the read commands RD are interleaved to the first to fourth memory chips MC1 to MC4. Herein, the interleaving means that time points or intervals where commands are applied are distributed on the time domain.

The input/output circuit IOC transmits the first command CMD1 to the first memory chip MC1 through the first command (CMD1) input/output line during the time interval from t1 to t2, transmits the second command CMD2 to the second memory chip MC2 through the second command (CMD2) input/output line during the time interval including t2 to t3, transmits the third command CMD3 to the third memory chip MC3 through the third command (CMD3) input/output line during the time interval including t3 to t4, and transmits the fourth command CMD4 to the fourth memory chip MC4 through the fourth command (CMD4) input/output line during the time interval including t4 to t5.

The control logic circuits control the core operations for the memory chips based on the read commands RD received at different time points. For example, during tR1 which is defined as a time interval from t2 to t6, the first control logic circuit CLC1-1/CLC1-2 controls the first page buffer circuit PBC1-1/PBC1-2 such that data stored in the first memory cell array MCA1-1/MCA1-2 are dumped to the first cache latch. During tR2 which is defined as a time interval from t3 to t7, the second control logic circuit CLC2-1/CLC2-2 controls the second page buffer circuit PBC2-1/PBC2-2 such that data stored in the second memory cell array MCA2-1/MCA2-2 are dumped to the second cache latch.

During tR3 which is defined as a time interval from t4 to t8, the third control logic circuit CLC3-1/CLC3-2 controls the third page buffer circuit PBC3-1/PBC3-2 such that data stored in the third memory cell array MCA3-1/MCA3-2 are dumped to the third cache latch. During tR4 which is defined as a time interval from t5 to t9, the fourth control logic circuit CLC4-1/CLC4-2 controls the fourth page buffer circuit PBC4-1/PBC4-2 such that data stored in the fourth memory cell array MCA4-1/MCA4-2 are dumped to the fourth cache latch.

Since the control logic circuits control the page buffer circuits based on the interleaved commands, the core operations of the memory chips including the dumping to the first to fourth cache latches may be performed in parallel. Accordingly, as memory chips are stacked, the performance of the core operation may be improved.

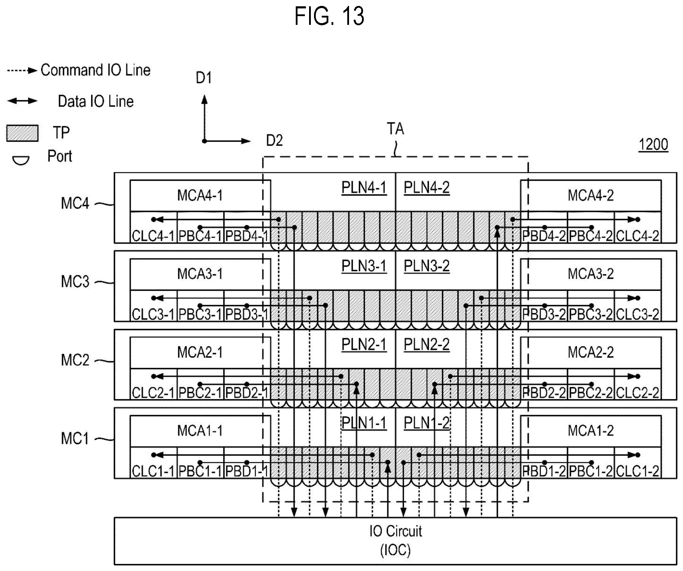

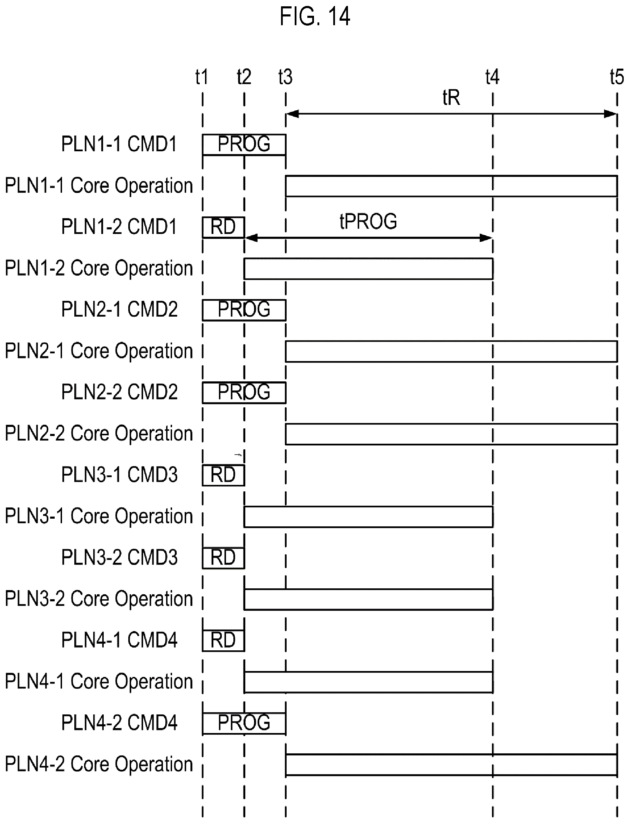

FIG. 13 illustrates a read operation and a program operation of the non-volatile memory device 1200, according to an embodiment, and FIG. 14 illustrates how to apply the read command RD and the program command to the non-volatile memory device 1200 and how to perform the core operation, according to an embodiment.

Referring to FIGS. 13 and 14, the non-volatile memory device 1200 according to an embodiment may perform the read operations and the program operations on respective memory chips and planes in parallel. In an embodiment, the read operation and the program operation may be performed in parallel on planes included in one memory chip. In an embodiment, the read operations and the program operations may be performed in parallel on memory chips.

At a time point t1, the read commands RD or write commands PROG are applied to respective memory chips and planes. For example, the write command PROG may be applied to each of the (1-1)-th plane PLN1-1, the (2-1)-th plane PLN2-1, the (2-2)-th plane PLN2-2, and the (4-2)-th plane PLN4-2, and the read command RD may be applied to each of the (1-2)-th plane PLN1-2, the (3-1)-th plane PLN3-1, the (3-2)-th plane PLN3-2, and the (4-1)-th plane PLN4-1.

During a time interval from t1 to t3 in which the program command is applied, the input/output circuit IOC transmits the first command CMD1 indicating the program operation to the (1-1)-th plane PLN1-1 through the first command (CMD1) input/output line, transmits the second command CMD2 indicating the program operation to the (2-1)-th plane PLN2-1 through the second command (CMD2) input/output line, transmits the second command CMD2 indicating the program operation to the (2-2)-th plane PLN2-2 through the second command (CMD2) input/output line, and transmits the fourth command CMD4 indicating the program operation to the (4-2)-th plane PLN4-2 through the fourth command (CMD4) input/output line.

During a time interval from t1 to t2 in which the read command RD is applied, the input/output circuit IOC transmits the first command CMD1 indicating the read operation to the (1-2)-th plane PLN1-2 through the first command (CMD1) input/output line, transmits the third command CMD3 indicating the read operation to the (3-1)-th plane PLN3-1 through the third command (CMD3) input/output line, transmits the third command CMD3 indicating the read operation to the (3-2)-th plane PLN3-2 through the third command (CMD3) input/output line, and transmits the fourth command CMD4 indicating the read operation to the (4-1)-th plane PLN4-1 through the fourth command (CMD4) input/output line.

According to the above embodiment illustrated in FIGS. 13-14, the input/output circuit IOC may perform the following operations in parallel: an operation of transmitting the first command CMD1 indicating the read operation to the first control logic circuit CLC1-1/CLC1-2 connected to one first plane among the plurality of first planes PLN1-1 and PLN1-2 through the first command (CMD1) input/output line connected to the one first plane, and an operation of transmitting the second command CMD2 indicating the program operation to the first control logic circuit CLC1-1/CLC1-2 connected to another first plane among the plurality of first planes PLN1-1 and PLN1-2 through the first command (CMD1) input/output line connected to the another first plane.

Each control logic circuit controls the core operation for each memory chip based on the operation indicated by the command.

For example, based on the first command CMD1 indicating the program operation, the (1-1)-th control logic circuit CLC1-1 controls the (1-1)-th page buffer circuit PBC1-1 such that data received from the input/output circuit IOC are dumped to the first cache latch connected to the (1-1)-th plane PLN1-1. Based on the first command CMD1 indicating the read operation, the (1-2)-th control logic circuit CLC1-2 controls the (1-2)-th page buffer circuit PBC1-2 such that data stored in the (1-2)-th memory cell array MCA1-2 are dumped to the first cache latch connected to the (1-2)-th plane PLN1-2.

Based on the second command CMD2 indicating the program operation, the (2-1)-th control logic circuit CLC2-1 controls the (2-1)-th page buffer circuit PBC2-1 such that data received from the input/output circuit IOC are dumped to the second cache latch connected to the (2-1)-th plane PLN2-1. Based on the second command CMD2 indicating the program operation, the (2-2)-th control logic circuit CLC2-2 controls the (2-2)-th page buffer circuit PBC2-2 such that data received from the input/output circuit IOC are dumped to the second cache latch connected to the (2-2)-th plane PLN2-2.

Based on the third command CMD3 indicating the read operation, the (3-1)-th control logic circuit CLC3-1 controls the (3-1)-th page buffer circuit PBC3-1 such that data stored in the (3-1)-th memory cell array MCA3-1 are dumped to the third cache latch connected to the (3-1)-th plane PLN3-1. Based on the third command CMD3 indicating the read operation, the (3-2)-th control logic circuit CLC3-2 controls the (3-2)-th page buffer circuit PBC3-2 such that data stored in the (3-2)-th memory cell array MCA3-2 are dumped to the third cache latch connected to the (3-2)-th plane PLN3-2.

Based on the fourth command CMD4 indicating the read operation, the (4-1)-th control logic circuit CLC4-1 controls the (4-1)-th page buffer circuit PBC4-1 such that data stored in the (4-1)-th memory cell array MCA4-1 are dumped to the fourth cache latch connected to the (4-1)-th plane PLN4-1. Based on the fourth command CMD4 indicating the program operation, the (4-2)-th control logic circuit CLC4-2 controls the (4-2)-th page buffer circuit PBC4-2 such that data received from the input/output circuit IOC are dumped to the fourth cache latch connected to the (4-2)-th plane PLN4-2.

Since the page buffer circuit is controlled through each control logic circuit, during tR which is defined as the page read time and is between time point t3 and time point t5, the read core operations of the memory chips and planes including the dumping to the first to fourth cache latches may be performed in parallel. Also, Since the page buffer circuit is controlled through each control logic circuit, during tPROG which is defined as a page program time and is between time point t2 and time point t4, the program core operations of the memory chips and planes including the dumping to the first to fourth cache latches may be performed in parallel. Also, the read core operations and the program core operations may be performed in parallel.

In an embodiment, based on the first command CMD1 indicating the read operation, a first control logic circuit controls a first page buffer circuit such that data stored in a first memory cell array are dumped to a first cache latch connected to one first plane.

In an embodiment, based on the first command CMD1 indicating the program operation, a first control logic circuit controls a second page buffer circuit such that data received from the input/output circuit IOC are dumped to the first cache latch connected to another first plane. Accordingly, the dumping to the first cache latch connected to one first plane and the dumping to the first cache latch associated with another first plane are performed in parallel.

The non-volatile memory device 1200 according to the above embodiment illustrated in FIGS. 13-14 may perform the read and program core operations in parallel through input/output lines provided for respective memory chips and planes. Accordingly, as memory chips are stacked, the performance of the core operation may be improved.

In the non-volatile memory device 1200 according to the above embodiments, a plurality of command input/output lines and/or a plurality of data input/output lines may be connected to one plane according to an embodiment. Accordingly, embodiments of the present disclosure are not limited to FIGS. 7, 9, 10, and 13.

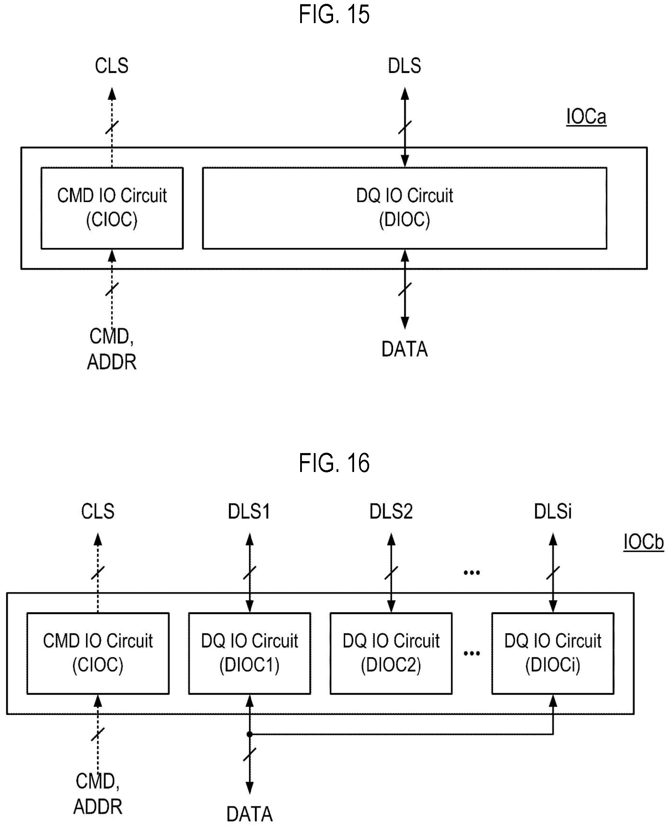

FIG. 15 is a block diagram of an input/output circuit according to an embodiment.

Referring to FIGS. 9 and 15, an input/output circuit IOCa according to an embodiment includes a command input/output circuit CIOC and a data input/output circuit DIOC. The input/output circuit IOCa may correspond to the input/output circuit IOC as described in the above embodiments (refer to FIGS. 1, 9, 10, and 13).

The command input/output circuit CIOC is connected to the command input/output line set CLS and is configured to receive the command CMD and the address ADDR from the memory controller (e.g., refer to FIG. 1) through the command input/output line set CLS and to output the received command CMD and the received address ADDR to the plurality of memory chips MC1 to MCm. To transmit the command CMD and the address ADDR for each memory chip and plane, the command input/output circuit CIOC may include a plurality of command input/output pads.

The command input/output circuit CIOC processes the received command CMD and the received address ADDR and outputs a signal for memory chip and plane-specific control to the command input/output line set CLS. Each command input/output line included in the command input/output line set CLS transfers the signal to the corresponding memory chip and plane.

The data input/output circuit DIOC is connected to the data input/output line set DLS and is configured to receive the data "DATA" from the memory controller and to output the received data "DATA" to the plurality of memory chips MC1 to MCm, or is configured to output the data read from the plurality of memory chips MC1 to MCm to the memory controller. To transmit the data "DATA" for each memory chip and plane, the data input/output circuit DIOC may include a plurality of data input/output pads.

Each data input/output line included in the data input/output line set DLS transfers the data to the corresponding memory chip and plane.

The data input/output circuit DIOC is configured to perform serializing and deserializing of data. In an embodiment, the data transferred from the plurality of memory chips MC1 to MCm are transferred to the data input/output circuit DIOC in units of N-byte width (N being a natural number). In this case, a data rate of the data transferred to the data input/output circuit DIOC is 1/N of the target data rate.

The data input/output circuit DIOC serializes the transferred data based on the 1-byte width and the target data rate. The data input/output circuit DIOC outputs the serialized data with the 1-byte width to the memory controller at the target data rate.

In an embodiment, the data input/output circuit DIOC may be connected to data input/output lines for all the planes. For example, the data input/output circuit DIOC may be connected to a first data input/output line for all the first planes, a second data input/output line for all the second planes, a third data input/output line for all the third planes, and a fourth data input/output line for all the fourth planes.

FIG. 16 is a block diagram including a plurality of data input/output circuits according to an embodiment.

Referring to FIGS. 9 and 16, an input/output circuit IOCb according to an embodiment includes the command input/output circuit CIOC and a plurality of data input/output circuits DIOC1 to DIOCi.

Each of the plurality of data input/output circuits DIOC1 to DIOCi may be connected to two or more different data input/output lines corresponding to two or more different planes. That is, each of data input/output line sets DLS1 to DLSi respectively connected to the data input/output lines includes two or more data input/output lines.

Assuming that each of the plurality of memory chips MC1 to MCm included in the memory stack corresponds to a layer, the plurality of layers may be classified into odd-numbered layers and even-numbered layers.

In an embodiment, a data input/output line for a plane corresponding to the odd-numbered layer and a data input/output line for a plane corresponding to the even-numbered layer may be connected to one data input/output circuit.

In an embodiment, when a plurality of data input/output lines are connected to one plane, the plurality of data input/output lines connected to one plane may be connected to one data input/output circuit. In this case, data corresponding to one plane are distributed and transmitted to the plurality of data input/output lines.

In an embodiment, data input/output lines corresponding to one odd-numbered layer among the odd-numbered layers and an even-numbered layer continuous to the one odd-numbered layer may be connected to one data input/output circuit.

For example, the first data input/output circuit DIOC1 is connected to the first data input/output line set DLS1 which includes a first data input/output line for one first plane among a plurality of first planes and a second data input/output line for one second plane among a plurality of second planes. The second data input/output circuit DIOC2 is connected to the second data input/output line set DLS2 which includes a third data input/output line for one third plane among a plurality of third planes and a fourth data input/output line for one fourth plane among a plurality of fourth planes.

One data input/output circuit may perform the serialization of data receive from the data input/output line and the output to the memory controller.

For example, it is assumed that, in the non-volatile memory device including four layers as illustrated in FIG. 9, each layer includes 16 planes. In this case, the number of planes included in the non-volatile memory device is 64. Accordingly, 64 plane data sets are transferred to the data input/output circuit.

According to an embodiment, when data input/output lines corresponding to an odd-numbered layer and an even-numbered layer continuous to the odd-numbered layer are connected to one data input/output circuit, the number of data input/output circuits DIOC1 to DIOCi constituting the input/output circuit may be 32. In this case, one data input/output circuit is connected to two data input/output lines connected to two planes. One data input/output circuit serializes the data received from the two data input/output lines to 1-byte data.

Accordingly, the input/output circuit IOCb is capable of operating based on the 32-byte IO throughput.

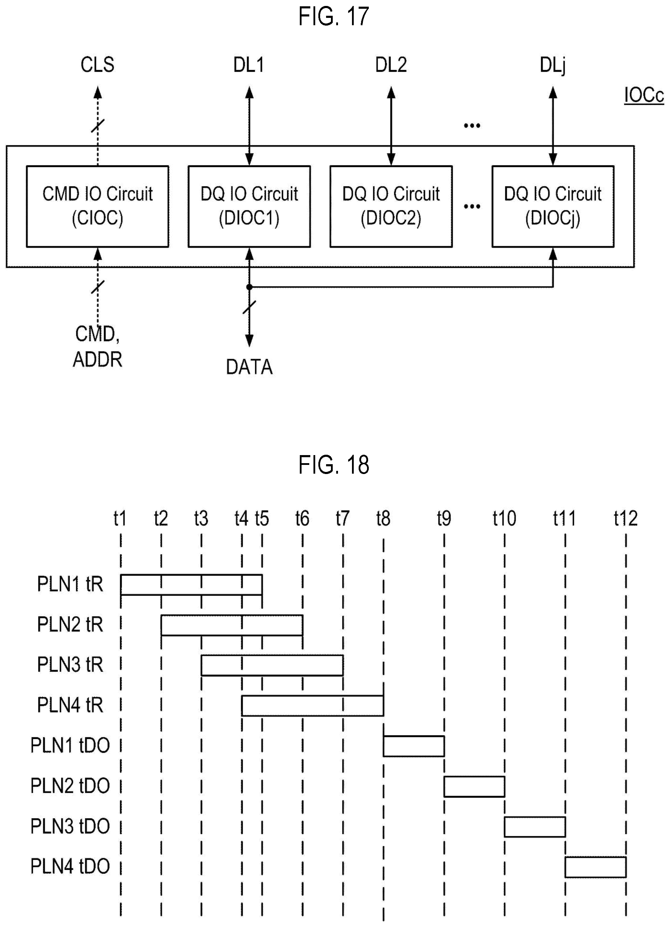

FIG. 17 is a block diagram including a plurality of data input/output circuits according to an embodiment.

Referring to FIGS. 9 and 17, an input/output circuit IOCc according to an embodiment includes the command input/output circuit CIOC and a plurality of data input/output circuits DIOC1 to DIOCj.

Unlike FIG. 16, each of the plurality of data input/output circuits DIOC1 to DIOCj of FIG. 17 may correspond to one memory chip and one plane. In other words, the number of data input/output circuits DIOC1 to DIOCj may be the same as the number of planes included in the non-volatile memory device.

Accordingly, one data input/output line among a plurality of data input/output lines is connected to the one data input/output circuit.

For example, the first data input/output circuit DIOC1 is connected to the first data input/output line DL1 for one first plane among a plurality of first planes, the second data input/output circuit DIOC2 is connected to the second data input/output line DL2 for one second plane among a plurality of second planes, and the j-th data input/output circuit DIOCj is connected to the j-th data input/output line DLj for one j-th plane among a plurality of j-th planes.

One data input/output circuit serializes data received through one data input/output line.

For example, it is assumed that, in the non-volatile memory device including four layers as illustrated in FIG. 9, each layer includes 16 planes. When the plurality of data input/output circuits DIOC1 to DIOCj and the plurality of planes are mapped in a one-to-one correspondence, 64 data input/output circuits may be provided. In this case, one data input/output circuit is connected to one data input/output line connected to one plane. One data input/output circuit serializes the data received from one data input/output line to 1-byte data.

Accordingly, the input/output circuit is capable of operating based on the 64-byte IO throughput.

The input/output circuit according to the above embodiments may improve I/O performance through the plurality of data input/output circuits DIOC1 to DIOCj.

FIG. 18 illustrates a page read operation and a data output operation for each plane, according to an embodiment.

Referring to FIGS. 9 and 18, the page read operation is classified as the core operation, and the data output operation means an operation in which data are transferred from the above memory chip (or core die) to the input/output circuit (or the base die). A page read operation time is defined as tR, and a data output operation time is defined tDO.

In an embodiment, each cache latch may output the cached data after a given caching time. That is, the cache latch may store the cached data during the given caching time and may then output the cached data to the data input/output line. For example, the first cache latch connected to one first plane PLN1 among the plurality of first planes PLN1 may output the cached data after the given caching time.

According to the above description, the input/output circuit may receive the data output from the cache latch after the given caching time through the data input/output line which is provided in the TSV area that penetrates the plurality of memory chips MC1 to MCm along the first direction D1 and which is connected for each of a plurality of planes. In other words, the page read operation and the data output operation may be performed asynchronously.

For example, the page read operation is performed sequentially on the first to fourth planes PLN1 to PLN4. The page read time of the first plane PLN1 is defined as a time interval from t1 to t5, the page read time of the second plane PLN2 is defined as a time interval from t2 to t6, the page read time of the third plane PLN3 is defined as a time interval from t3 to t7, and the page read time of the fourth plane PLN4 is defined as a time interval from t4 to t8. During each page read time, data are dumped to the page buffer circuit included in each plane. Also, the data are cached by the cache latch included in the page buffer circuit.

The data output operation for the first plane PLN1 is performed from t8 at which the given caching time has passed from a time point at which the page read operation of the first plane PLN1 is terminated. The data output operation for the second plane PLN2 is performed from t9 at which the given caching time has passed from a time point at which the page read operation of the second plane PLN2 is terminated. The data output operation for the third plane PLN3 is performed from t10 at which the given caching time has passed from a time point at which the page read operation of the third plane PLN3 is terminated. The data output operation for the fourth plane PLN4 is performed from t11 at which the given caching time has passed from a time point at which the page read operation of the fourth plane PLN4 is terminated.

According to the above embodiment illustrated with respect to FIG. 18, because the non-volatile memory device is capable of caching data, the data output operation may be performed even after a given time passes from a time point at which the page read operation is completed. Accordingly, the page read operations and the data output operations for the plurality of planes are capable of being performed in parallel without the interleaving for the plurality of planes.

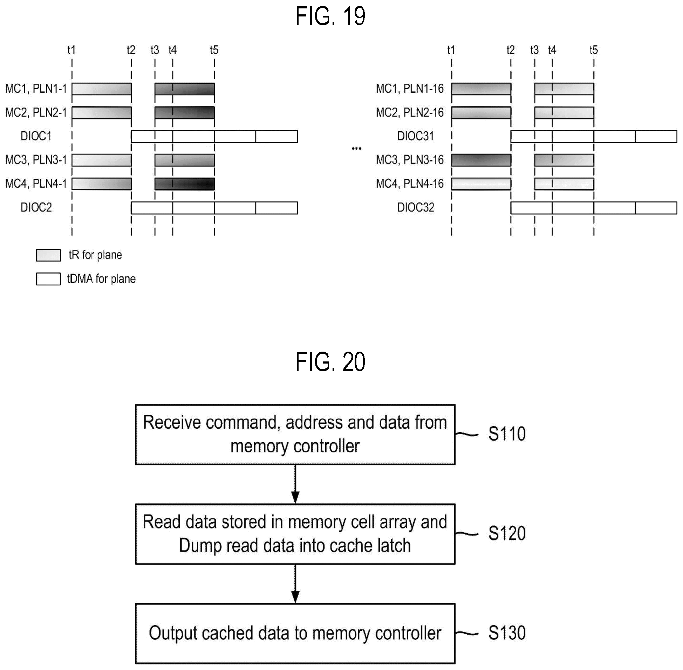

FIG. 19 illustrates a data read operation and a data output operation for each plane, according to an embodiment.

Referring to FIG. 19, in an embodiment, it is assumed that the number of stacked memory chips of the non-volatile memory device is 4 and the number of planes included in each memory chip is 16, and it is assumed that one data input/output circuit is provided every two planes associated with two adjacent layers.

In an embodiment, tR is the page read time as described above, and tDMA means a time during which data are output from the non-volatile memory device.

In association with the plurality of memory chips MC1 to MCm, the read command may be applied in parallel to a plurality of planes. In response to the read command, the peripheral circuit included in each plane performs the read operation. For example, the read operation is performed during tR defined as a time interval from t1 to t2. As the read operation is performed, data may be cached by the cache latch.

The data input/output circuit connected to two planes receives and process the cached data (i.e., the read data) from each of the two planes. In this case, the cached data may be output from one plane to the data input/output circuit after the given caching time. Accordingly, tDMA for one plane is defined as a time interval from t2 to t4, and tDMA for the other plane is defined as a time interval from t4 to t5.

For example, during the time interval from t2 to t4, the first data input/output circuit may receive the cached data of the (1-1)-th plane PLN1-1 (or the (2-1)-th plane PLN2-1) and may output the cached data to the memory controller. Afterwards, during the time interval from t4 to t5, the first data input/output circuit may receive the cached data of the (2-1)-th plane PLN2-1 (or the (1-1)-th plane PLN1-1) and may output the cached data to the memory controller.

Also, the read operation for another read data may be performed during a time interval from t3 to t5, and after t5, the data output operation for the cached data may be performed.

According to the above embodiment illustrated with respect to FIG. 19, because the core operations for the plurality of memory chips MC1 to MCm are performed to overlap each other, core performance may be improved. Also, as the plurality of data input/output circuits are provided in the non-volatile memory device where memory chips are stacked, I/O performance may be improved.

FIG. 20 is a flowchart of an operating method of a non-volatile memory device, according to an embodiment.

Referring to FIG. 20, in operation S110, a non-volatile memory device receives a command, an address, and data from a memory controller.

In operation S120, the non-volatile memory device may read data stored in the memory cell array and dump the read data into a cache latch. For example, based on the command indicating the read operation, the non-volatile memory device reads data stored in a memory cell array provided for each memory chip and plane and dumps the read data to the cache latch. Operation S120 may be performed in parallel on memory chips and planes at least in a given time interval.

In operation S130, the non-volatile memory device may output the cached data to the memory controller. For example, the non-volatile memory device outputs the cached data of the cache latch to the memory controller. Operation S130 may be performed on one plane after a given caching time from operation S120.

According to the present disclosure, a non-volatile memory device having a stacked structure through a through silicon via (TSV) area and having improved core and input/output (I/O) performance may be provided.

While the present disclosure has been described with reference to embodiments thereof, it will be apparent to those of ordinary skill in the art that various changes and modifications may be made thereto without departing from the scope of the claims.

Embodiments are set out in the following numbered clauses:
1. A non-volatile memory device comprising:
   a first memory chip including a plurality of first planes, each including a first memory cell array and a first page buffer circuit, the first page buffer circuit including a first cache latch that caches data sensed from the first memory cell array;
   a second memory chip stacked on the first memory chip along a first direction and including a plurality of second planes, each including a second memory cell array and a second page buffer circuit, the second page buffer circuit including a second cache latch that caches data sensed from the second memory cell array; and
   an input/output circuit configured to:
      communicate with each of the plurality of first planes of the first memory chip through a first data input/output line that is provided as a through via in a through silicon via (TSV) area of the first memory chip and the second memory chip along the first direction and connected for each of the plurality of first planes, and
      communicate with each of the plurality of second planes of the second memory chip through a second data input/output line that is provided as a through via in the TSV area and connected for each of the plurality of second planes.
2. The non-volatile memory device of clause 1, wherein the input/output circuit is connected to:
   a first command input/output line that is provided as a through via in the TSV area and connected for each of the plurality of first planes, and
   a second command input/output line that is provided as a through via in the TSV area and connected for each of the plurality of second planes.
3. The non-volatile memory device of clause 2, wherein each of the plurality of first planes further includes:
   a first control logic circuit configured to receive a first command for accessing the first memory cell array through the first command input/output line and to control each of the plurality of first planes based on the first command, and
   wherein each of the plurality of second planes further includes:
      a second control logic circuit configured to receive a second command for accessing the second memory cell array through the second command input/output line and to control each of the plurality of second planes based on the second command.
4. The non-volatile memory device of clause 3, wherein the input/output circuit performs, in parallel, transmitting the first command to the first control logic circuit through the first command input/output line and transmitting the second command to the second control logic circuit through the second command input/output line.
5. The non-volatile memory device of clause 4, wherein the first control logic circuit controls the first page buffer circuit based on the first command indicating a read operation for data stored in the first memory cell array such that the data stored in the first memory cell array are dumped to the first cache latch,
   wherein the second control logic circuit controls the second page buffer circuit based on the second command indicating a read operation for data stored in the second memory cell array such that the data stored in the second memory cell array are dumped to the second cache latch, and
   wherein the dumping to the first cache latch is performed in parallel with the dumping to the second cache latch.
6. The non-volatile memory device of any of clauses 3 to 5, wherein the input/output circuit performs, in parallel:
   transmitting the first command indicating a read operation to the first control logic circuit that is connected to one first plane among the plurality of first planes through the first command input/output line connected to the one first plane, and
   transmitting the second command indicating a program operation to the first control logic circuit that is connected to another first plane among the plurality of first planes through the first command input/output line connected to the another first plane.
7. The non-volatile memory device of clause 6, wherein the first control logic circuit is configured to:
   control the first page buffer circuit based on the first command indicating the read operation for data stored in the first memory cell array such that the data stored in the first memory cell array are dumped to the first cache latch that is connected to the one first plane; and
   control the second page buffer circuit based on the first command indicating a program operation for data received from the input/output circuit such that the data received from the input/output circuit are dumped to the first cache latch that is connected to the another first plane, and
   wherein the dumping to the first cache latch that is connected to the one first plane is performed in parallel with the dumping to the first cache latch that is connected to the another first plane.
8. The non-volatile memory device of any preceding clause, wherein the first cache latch that is connected to one first plane among the plurality of first planes is configured to output cached data after a given caching time.
9. The non-volatile memory device of any preceding clause, wherein the input/output circuit includes:
   a data input/output circuit that is connected to the first data input/output line associated with all the plurality of first planes and that is connected to the second data input/output line associated with all the plurality of second planes.
10. The non-volatile memory device of any preceding clause, further comprising:
   a third memory chip that is stacked on the second memory chip along the first direction and that includes a plurality of third planes, each including a third memory cell array; and
   a fourth memory chip that is stacked on the third memory chip along the first direction and that includes a plurality of fourth planes, each including a fourth memory cell array, and
   wherein the input/output circuit is configured to:
      communicate with each of the plurality of third planes of the third memory chip through a third data input/output line that is provided as a through via in the TSV area and connected for each of the plurality of third planes; and
      communicate with each of the plurality of fourth planes of the fourth memory chip through a fourth data input/output line that is provided as a through via in the TSV area and connected for each of the plurality of fourth planes.
11. The non-volatile memory device of clause 10, wherein the input/output circuit includes:
   a first data input/output circuit that is connected to the first data input/output line associated with one first plane among the plurality of first planes and that is connected to the second data input/output line associated with one second plane among the plurality of second planes; and
   a second data input/output circuit that is connected to the third data input/output line associated with one third plane among the plurality of third planes and that is connected to the fourth data input/output line associated with one fourth plane among the plurality of fourth planes.
12. The non-volatile memory device of any preceding clause, wherein the input/output circuit includes:
   a first data input/output circuit that is connected to the first data input/output line associated with one first plane among the plurality of first planes; and
   a second data input/output circuit that is connected to the second data input/output line associated with one second plane among the plurality of second planes.
13. A non-volatile memory device comprising:
   a base die; and
   a plurality of memory chips sequentially stacked on the base die along a first direction,
   wherein each of the plurality of memory chips includes:
      a plurality of planes, each including a memory cell array and a page buffer circuit, the page buffer circuit including a cache latch that caches data sensed from the memory cell array, and
   wherein the base die includes:
      an input/output circuit configured to communicate with each of the plurality of planes of the plurality of memory chips through a data input/output line that is provided as a through via in a through silicon via (TSV) area of the plurality of memory chips along the first direction and connected for each of the plurality of planes.
14. The non-volatile memory device of clause 13, wherein the input/output circuit is connected to a command input/output line that is provided as a through via in the TSV area and connected for each of the plurality of planes.
15. The non-volatile memory device of clause 14, wherein each of the plurality of planes further includes:
   a control logic circuit configured to receive a command for accessing the memory cell array through the command input/output line and to control each of the plurality of planes based on the command, and
   wherein the input/output circuit transmits the command to the control logic circuit through the command input/output line in parallel to the plurality of memory chips and to the plurality of planes.
16. The non-volatile memory device of any of clauses 13 to 15, wherein the input/output circuit includes:
   a data input/output circuit that is connected to the data input/output line in association with all the plurality of planes.
17. The non-volatile memory device of any of clauses 13 to 16, wherein the input/output circuit includes:
   a first data input/output circuit that is connected to the data input/output line associated with a first plane among the plurality of planes and that is connected to the data input/output line associated with a second plane among the plurality of planes; and
   a second data input/output circuit that is connected to the data input/output line associated with a third plane among the plurality of planes and that is connected to the data input/output line associated with a fourth plane among the plurality of planes.
18. The non-volatile memory device of any of clauses 13 to 17, wherein the input/output circuit includes:
   a first data input/output circuit that is connected to the data input/output line associated with a first plane among the plurality of planes; and
   a second data input/output circuit that is connected to the data input/output line associated with a second plane among the plurality of planes.
19. A non-volatile memory device comprising:
   a plurality of memory chips sequentially stacked along a first direction; and
   an input/output circuit connected to the plurality of memory chips,
   wherein each of the plurality of memory chips includes:
      a plurality of planes, each including a memory cell array and a page buffer circuit, the page buffer circuit including a cache latch that caches data sensed from the memory cell array,
   wherein the input/output circuit is configured to:
      receive, for each of the plurality of planes, data output from the cache latch after a given caching time through a data input/output line that is provided as a through via in a through silicon via (TSV) area of the plurality of memory chips along the first direction and connected for each of the plurality of planes.
20. The non-volatile memory device of clause 19, wherein the input/output circuit is configured to:
   transmit commands to the plurality of planes in parallel through a command input/output line that is provided as a through via in the TSV area and connected for each of the plurality of planes.

## Claims

1. A non-volatile memory device comprising:
a first memory chip (MC1) including a plurality of first planes (PLN1-1...PLN1-n), each including a first memory cell array (MCA1-1...MCA1-n) and a first page buffer circuit (PBC1-1...PBC1-n), the first page buffer circuit (PBC1-1...PBC1-n) including a first cache latch configured to cache data sensed from the first memory cell array (MCA1-1...MCA1-n);
a second memory chip (MC2) stacked on the first memory chip (MC1) along a first direction (D1) and including a plurality of second planes (PLN2-1...PLN2-n), each including a second memory cell array (MCA2-1...MCA2-n) and a second page buffer circuit (PBC2-1...PBC2-n), the second page buffer circuit (PBC2-1...PBC2-n) including a second cache latch configured to cache data sensed from the second memory cell array (MCA2-1...MCA2-n); and
an input/output circuit (IOC) configured to:
communicate with each of the plurality of first planes (PLN1-1...PLN1-n) of the first memory chip (MC1) through a first data input/output line that is provided as a through via in a through silicon via, TSV, area of the first memory chip (MC1) and the second memory chip (MC2) along the first direction (D1) and connected for each of the plurality of first planes (PLN1-1...PLN1-n), and
communicate with each of the plurality of second planes (PLN2-1...PLN2-n)of the second memory chip (MC2) through a second data input/output line that is provided as a through via in the TSV area and connected for each of the plurality of second planes (MC2).

2. The non-volatile memory device of claim 1, wherein the input/output circuit (IOC) is connected to:
a first command input/output line that is provided as a through via in the TSV area and connected for each of the plurality of first planes, and
a second command input/output line that is provided as a through via in the TSV area and connected for each of the plurality of second planes.

3. The non-volatile memory device of claim 2, wherein each of the plurality of first planes (PLN1-1...PLN1-n) further includes:
a first control logic circuit (CLC1-1/CLC1-2) configured to receive a first command for accessing the first memory cell array (MCA1-1...MCA1-n) through the first command input/output line and to control each of the plurality of first planes (PLN1-1...PLN1-n) based on the first command, and
wherein each of the plurality of second planes (PLN2-1...PLN2-n) further includes:
a second control logic circuit (CLC2-1/CLC2-2) configured to receive a second command for accessing the second memory cell array (MCA2-1...MCA2-n) through the second command input/output line and to control each of the plurality of second planes (PLN2-1...PLN2-n) based on the second command.

4. The non-volatile memory device of claim 3, wherein the input/output circuit (IOC) is configured to perform, in parallel, transmitting the first command to the first control logic circuit (CLC1-1/CLC1-2) through the first command input/output line and transmitting the second command to the second control logic circuit (CLC2-1/CLC2-2) through the second command input/output line.

5. The non-volatile memory device of claim 4, wherein the first control logic circuit (CLC1-1/CLC1-2) is configured to control the first page buffer circuit (PBC1-1...PBC1-n) based on the first command indicating a read operation for data stored in the first memory cell array (MCA1-1...MCA1-n) such that the data stored in the first memory cell array (MCA1-1...MCA1-n) are dumped to the first cache latch,
wherein the second control logic circuit (CLC2-1/CLC2-2) is configured to control the second page buffer circuit (PBC2-1...PBC2-n) based on the second command indicating a read operation for data stored in the second memory cell array (MCA2-1...MCA2-n) such that the data stored in the second memory cell array are (MCA2-1...MCA2-n) dumped to the second cache latch,
such that the dumping to the first cache latch is performed in parallel with the dumping to the second cache latch.

6. The non-volatile memory device of any of claims 3 to 5, wherein the input/output circuit (IOC) is configured to perform, in parallel:
transmitting the first command indicating a read operation to the first control logic circuit (CLC1-1/CLC1-2) that is connected to one first plane among the plurality of first planes (PLN1-1...PLN1-n) through the first command input/output line connected to the one first plane, and
transmitting the second command indicating a program operation to the first control logic circuit (CLC1-1/CLC1-2) that is connected to another first plane among the plurality of first planes (PLN1-1...PLN1-n) through the first command input/output line connected to the another first plane.

7. The non-volatile memory device of claim 6, wherein the first control logic circuit (CLC1-1/CLC1-2) is configured to:
control the first page buffer circuit (PBC1-1...PBC1-n) based on the first command indicating the read operation for data stored in the first memory cell array (MCA1-1...MCA1-n) such that the data stored in the first memory cell array (MCA1-1...MCA1-n) are dumped to the first cache latch that is connected to the one first plane; and
control the second page buffer circuit (PBC2-1...PBC2-n) based on the first command indicating a program operation for data received from the input/output circuit (IOC) such that the data received from the input/output circuit (IOC) are dumped to the first cache latch that is connected to the another first plane,
such that the dumping to the first cache latch that is connected to the one first plane is performed in parallel with the dumping to the first cache latch that is connected to the another first plane.

8. The non-volatile memory device of any preceding claim, wherein the first cache latch that is connected to one first plane among the plurality of first planes (PLN1-1...PLN1-n) is configured to output cached data after a given caching time.

9. The non-volatile memory device of any preceding claim, wherein the input/output circuit (IOC) includes:
a data input/output circuit (DIOC) that is connected to the first data input/output line associated with all the plurality of first planes and that is connected to the second data input/output line associated with all the plurality of second planes.

10. The non-volatile memory device of any preceding claim, further comprising:
a third memory chip (MC3) that is stacked on the second memory chip (MC2) along the first direction (D1) and that includes a plurality of third planes (PLN3-1...PLN3-n), each including a third memory cell array (MCA1-1...MCA1-n); and
a fourth memory chip (MC4) that is stacked on the third memory chip (MC3) along the first direction (D1) and that includes a plurality of fourth planes (PLN4-1...PLN4-n), each including a fourth memory cell array (MCA4-1...MCA4-n), and
wherein the input/output circuit (IOC) is configured to:
communicate with each of the plurality of third planes (PLN3-1...PLN3-n) of the third memory chip (MC3) through a third data input/output line that is provided as a through via in the TSV area and connected for each of the plurality of third planes (PLN3-1...PLN3-n); and
communicate with each of the plurality of fourth planes (PLN4-1...PLN4-n) of the fourth memory chip (MC4) through a fourth data input/output line that is provided as a through via in the TSV area and connected for each of the plurality of fourth planes (PLN4-1...PLN4-n).

11. The non-volatile memory device of claim 10, wherein the input/output circuit (IOC) includes:
a first data input/output circuit (DIOC1) that is connected to the first data input/output line associated with one first plane among the plurality of first planes (PLN1-1...PLN1-n) and that is connected to the second data input/output line associated with one second plane among the plurality of second planes (PLN2-1...PLN2-n); and
a second data input/output circuit (DIOC2) that is connected to the third data input/output line associated with one third plane among the plurality of third planes (PLN3-1...PLN3-n) and that is connected to the fourth data input/output line associated with one fourth plane among the plurality of fourth planes (PLN4-1...PLN4-n).

12. The non-volatile memory device of claims 1 to 10, wherein the input/output circuit (IOC) includes:
a first data input/output circuit (DIOC1) that is connected to the first data input/output line associated with one first plane among the plurality of first planes (PLN1-1...PLN1-n); and
a second data input/output circuit (DIOC2) that is connected to the second data input/output line associated with one second plane among the plurality of second planes (PLN2-1...PLN2-n).

13. A non-volatile memory device comprising:
a base die; and
a plurality of memory chips (MC) sequentially stacked on the base die along a first direction (D1),
wherein each of the plurality of memory chips (MCA) includes:
a plurality of planes (PLN), each including a memory cell array (MCA) and a page buffer circuit (PBC), the page buffer circuit (PBC) including a cache latch that is configured to cache data sensed from the memory cell array (MCA), and
wherein the base die includes:
an input/output circuit (IOC) configured to communicate with each of the plurality of planes (PLN) of the plurality of memory chips (MC) through a data input/output line that is provided as a through via in a through silicon via (TSV) area of the plurality of memory chips (MC) along the first direction (D1) and connected for each of the plurality of planes (PLN).

14. The non-volatile memory device of claim 13, wherein the input/output circuit (IOC) is connected to a command input/output line that is provided as a through via in the TSV area and connected for each of the plurality of planes (PLN).

15. The non-volatile memory device of claim 14, wherein each of the plurality of planes (PLN) further includes:
a control logic circuit (CLC) configured to receive a command for accessing the memory cell array (MCA) through the command input/output line and to control each of the plurality of planes (PLN) based on the command, and
wherein the input/output circuit (IOC) is configured to transmit the command to the control logic circuit (CLC) through the command input/output line in parallel to the plurality of memory chips (MC) and to the plurality of planes (PLN).
